# EUROPEAN PATENT SPECIFICATION

(11) **EP 4 521 719 B1**
(45) Date of publication and mention of the grant of the patent: **07.10.2026**
(21) Application number: 23819041.7
(22) Date of filing: 05.06.2023
(51) Int. Cl.: H04L 67/5651, H03M 7/30

(54) **DATA PROCESSING METHOD AND RELATED DEVICE**
DATENVERARBEITUNGSVERFAHREN UND ZUGEHÖRIGE VORRICHTUNG
PROCÉDÉ DE TRAITEMENT DE DONNÉES ET DISPOSITIF ASSOCIÉ

(30) Priority: 09.06.2022 CN 202210647535
(43) Date of publication of application: 12.03.2025
(73) Proprietor: Huawei Technologies Co., Ltd., Shenzhen, Guangdong 518129 (CN)
(72) Inventor: SUN, Chao, Shenzhen, Guangdong 518129 (CN); CHENG, Jian, Shenzhen, Guangdong 518129 (CN); ZHANG, Liang, Shenzhen, Guangdong 518129 (CN); CUI, Hongbin, Shenzhen, Guangdong 518129 (CN)
(74) Representative: MERH-IP Matias Erny Reichl Hoffmann Patentanwälte PartG mbB
(86) International application number: PCT/CN2023/098195
(87) International publication number: WO 2023/236876

(56) References cited:
- CN-A- 1 475 047
- CN-A- 1 956 391
- CN-A- 102 194 499
- CN-A- 104 346 426
- US-A1- 2007 002 780
- US-A1- 2019 089 371
- HE Y ET AL: "SCCE3: Test A.5 - Palette table prediction", 18. JCT-VC MEETING; 30-6-2014 - 9-7-2014; SAPPORO; (JOINT COLLABORATIVE TEAM ON VIDEO CODING OF ISO/IEC JTC1/SC29/WG11 AND ITU-T SG.16 ); URL: HTTP://WFTP3.ITU.INT/AV-ARCH/JCTVC-SITE/,, no. JCTVC-R0166, 21 June 2014 (2014-06-21), XP030116450

## Description

This application claims priority to Chinese Patent Application No. 202210647535.2, filed with the China National Intellectual Property Administration on June 9, 2022, and entitled "DATA PROCESSING METHOD AND RELATED DEVICE".

### TECHNICAL FIELD

This application relates to the field of communication technologies, and in particular, to a data processing method and a related device.

### BACKGROUND

With popularity of cloud computing, an increasingly large amount of data is transmitted in a network between data centers that carries cloud computing services or transmitted between a data center and a local network.

If an ingress device in the data center or local network supports data compression, an amount of data transmitted between networks can be greatly reduced. To avoid aging of a compression parameter, each network device in a networking scenario needs to continuously update the compression parameter. Any two network devices that communicate with each other need to continuously transmit an updated compression parameter.

Therefore, when the networking scenario includes a large quantity of network devices, each network device needs to synchronize a compression parameter with any other network device, to locally maintain a latest compression parameter for each other network device. This results in high complexity of maintaining the compression parameter between the network devices, and each network device further needs to store a plurality of compression parameters.
Document US 2019/089371 A1 generally discloses a log collection device including: a log receiver that receives a text log from a log generation device; a dictionary generator that generates a compressed dictionary for performing text compression based on the received text log; a dictionary transmitter that transmits the generated compressed dictionary to the log generation device and instructs performing of the compression process using the compressed dictionary on the text log transmitted after the transmission of the compressed dictionary; and a decompression processor that performs a decompression process using the compressed dictionary on the text log received after transmission of the compressed dictionary.
Document HE Y ET AL, "SCCE3: Test A.5 - Palette table prediction", 18. JCT-VC MEETING; 30-6-2014 - 9-7-2014; SAPPORO; (JOINT COLLABORATIVE TEAM ON VIDEO CODING OF ISO/IEC JTC1/SC29/WG11 AND ITU-T SG.16); 20140621, no. JCTVC-R0166 generally reports the simulation results for palette table prediction (SCCE3 Test A.5).
Document CN 1 956 391 A generally discloses a method for collecting data from nodes of a telecommunication network, said network comprising a collecting node and an intermediate node, wherein it comprises the steps, which are performed by the intermediate node, of: receiving from said collecting node a first file comprising at least a first compressed data set and a first dictionary; generating a second file comprising at least a second compressed data set and a second dictionary; merging said first dictionary and said second dictionary into a resulting dictionary; and inserting said resulting dictionary, said first compressed data set and said second compressed data set into an overall file.

### SUMMARY

This application provides a data processing method, to reduce a quantity of compression parameters stored by a network device, and reduce complexity of maintaining the compression parameter by the network device. In particular, this application provides data processing methods and a network device, having the features of respective independent claims. The dependent claims relate to preferred embodiments.

A first aspect of this application provides a data processing method. The method may be performed by a first network device, or may be performed by a component (for example, a main control board, a service board, a switch fabric, or an interface board) of the first network device. The method includes: The first network device obtains a first local compression parameter and a second local compression parameter, where the first local compression parameter is generated by the first network device or a second network device, and the second local compression parameter is generated by a third network device; and the first network device generates a first global compression parameter based on the first local compression parameter and the second local compression parameter, where the first global compression parameter is for compression and decompression.

In this technical solution, the first network device obtains a plurality of local compression parameters, and generates a global compression parameter based on the plurality of local compression parameters. The plurality of local compression parameters may be generated by a plurality of other network devices. For example, the plurality of other network devices include the second network device and the third network device. The global compression parameter is for compression or decompression. In this way, the network device only needs to maintain a few global compression parameters (for example, one global compression parameter), and the network device needs to synchronize only the compression parameter with the first network device, thereby reducing complexity of maintaining the compression parameter by the network device. In addition, the first network device updates the global compression parameter based on the local compression parameters generated by the plurality of other network devices, so that the global compression parameter is obtained based on a data processing result in a wider range. This further improves data compression efficiency.

Optionally, in a possible implementation of the first aspect, the first network device sends a synchronization request to the second network device and/or the third network device, to request the first local compression parameter and/or the second local compression parameter.

In this possible implementation, the first network device may collect the local compression parameters from the network devices in a manner of actively sending the synchronization request based on an actual requirement. This improves efficiency of updating/generating the global compression parameter by the first network device.

Optionally, in a possible implementation of the first aspect, the first network device sends a first compression policy to the second network device and/or the third network device, where the first compression policy includes a synchronization policy and/or a retention policy, the synchronization policy is used by the second network device and/or the third network device to generate and send a local compression parameter, and the retention policy indicates the second network device and/or the third network device to store at least one global compression parameter before the first global compression parameter.

In this possible implementation, the first network device may control the plurality of other network devices according to the first compression policy, so that the local compression parameters subsequently reported by the plurality of other network devices and a quantity of stored global compression parameters meet a compression parameter synchronization requirement of the first network device.

Optionally, in a possible implementation of the first aspect, the synchronization policy includes a service type and a compression policy corresponding to the service type, and the service type and the compression policy corresponding to the service type indicate the second network device and/or the third network device to process, according to the compression policy corresponding to the service type, a packet corresponding to the service type, and/or generate, according to the compression policy corresponding to the service type, a local compression parameter corresponding to the service type.

In this possible implementation, the first network device may set different compression policies for different service types. Packets of the different service types may have different characteristics, and therefore the packets of the different service types may have different compression ratios. After distinguishing the service types, a control device may generate a global compression parameter for a service type with a high compression ratio, and does not generate a global compression parameter for a service type with a low compression ratio, that is, the network device does not compress a packet of a service type with a low compression ratio. In addition, the different service types have different service requirements. For example, a speech-type service requires a low latency, and a download-type service requires a high throughput. The control device may generate different global compression parameters based on the service requirements of various service types.

Optionally, in a possible implementation of the first aspect, the first network device sends the first global compression parameter to at least one network device, where the at least one network device includes one or more of the following network devices: the second network device or the third network device.

In this possible implementation, the network device that reports the local compression parameter also receives the global compression parameter. In addition, the global compression parameter is generated based on the local compression parameter reported by the network device, and therefore the global compression parameter is more applicable to the network device.

Optionally, in a possible implementation of the first aspect, the first network device sends a first identifier to the at least one network device, where the first identifier identifies the first global compression parameter.

In this possible implementation, the identifier corresponding to the global compression parameter is sent, so that the at least one network device can clarify each global compression parameter. Therefore, the global compression parameter is accurately used subsequently by using the identifier.

Optionally, in a possible implementation of the first aspect, the first network device obtains a second compression policy, where the second compression policy includes one or more of the following: a moment or a periodicity at which the first network device generates/sends the first global compression parameter, a moment or a periodicity at which the first network device sends the synchronization request, the service type and the compression policy corresponding to the service type, and a preset condition, where the preset condition indicates the first network device to send the first global compression parameter when the preset condition is met.

In this possible implementation, the first network device may be controlled, according to the second compression policy, to perform a compression parameter synchronization process. For example, when the second compression policy is configured by an administrator, the compression parameter synchronization process may meet an actual requirement of the administrator.

Optionally, in a possible implementation of the first aspect, the first network device communicates with the second network device and/or the third network device based on a border gateway routing (Border Gateway Protocol, BGP) message, where communication information includes one or more of the following: the synchronization request, the first local compression parameter, the second local compression parameter, the first global compression parameter, or the first compression policy.

In this possible implementation, the first network device may communicate with the other network devices according to BGP. This improves implementation flexibility of this solution.

Optionally, in a possible implementation of the first aspect, the first local compression parameter, the second local compression parameter, and the first global compression parameter are dictionaries; and the first local compression parameter includes a first string, the second compression parameter includes a second string, and the first global compression parameter includes a union set of the first string and the second string.

In this possible implementation, the generated first global compression parameter not only includes the string in the first local compression parameter, but also includes the string in the second local compression parameter. This can further improve data compression efficiency.

Optionally, in a possible implementation of the first aspect, the first local compression parameter is a first local coding table, the second local compression parameter is a second local coding table, and the first global compression parameter is a first global coding table; the first local coding table includes a frequency or a quantity of times of a first element, the second local coding table includes a frequency or a quantity of times of a second element, and the first element and the second element are elements in a coding character set; and the first network device generates the first global coding table based on the frequency or the quantity of times of the first element and the frequency or the quantity of times of the second element, where the first global coding table includes elements in the coding character set and codeword corresponding to the elements.

In this possible implementation, the first network device generates the first global coding table based on occurrence frequencies or a quantity of occurrence times of elements in each local coding table. This can further improve data compression efficiency.

Optionally, in a possible implementation of the first aspect, the first network device obtains a second global compression parameter; and the first network device generates the first global compression parameter based on the first local compression parameter, the second local compression parameter, and the second global compression parameter.

In this possible implementation, the existing global compression parameter may be updated based on local compression parameters reported by the plurality of other network devices, so that an updated global compression parameter is generated based on more processed data. This further improves data compression efficiency.

Optionally, in a possible implementation of the first aspect, the preset condition includes at least one of the following: time of the first network device is a preset moment, or a time interval from a moment at which a global compression parameter is sent to the at least one network device last time reaches or exceeds a preset time period; a variation amount of a quantity of occurrence times or an occurrence frequency of at least one element in the first global compression parameter is greater than or equal to a first threshold; a difference between a length of a string in the first global compression parameter and a length of a string in the second global compression parameter is greater than or equal to a second threshold; a ratio of a length of a string in the first global compression parameter to a length of a string in the second global compression parameter is greater than or equal to a third threshold; and in a process of generating the first global compression parameter based on the second global compression parameter, a quantity of times of adjusting a sequence of substrings or elements in the second global compression parameter is greater than or equal to a fourth threshold.

In this possible implementation, the preset condition is set to control an occasion for sending the global compression parameter. For example, if a newly added string is greater than a threshold, the global compression parameter does not need to be synchronized when an update amount is small. This reduces consumption caused by compression parameter synchronization. In addition, a condition for sending the global compression parameter is limited, so that the first network device can more clearly clarify a condition for sending the global compression parameter.

A second aspect of this application provides a data processing method. The method may be performed by a second network device, or may be performed by a component (for example, a main control board, a service board, a switch fabric, or an interface board) of the second network device. The method includes: The second network device obtains a first local compression parameter; the second network device sends the first local compression parameter to a first network device; the second network device receives a first global compression parameter sent by the first network device, where the first global compression parameter is generated based on the first local compression parameter and a second local compression parameter; and the second network device compresses/decompresses target data based on the first global compression parameter, where the target data is data transmitted by the second network device.

In this technical solution, the second network device sends the first local compression parameter to the first network device, so that the first network device can generate the first global compression parameter based on the first local compression parameter. The second network device receives the first global compression parameter sent by the first network device, where the first global compression parameter is used to compress/decompress the target data transmitted by the second network device. In this way, the network device only needs to maintain a few global compression parameters (for example, one global compression parameter), and needs to synchronize only the compression parameters with the first network device, thereby reducing complexity of maintaining the compression parameter. In addition, the first global compression parameter is obtained by the first network device by updating local compression parameters generated by a plurality of other network devices, so that the first global compression parameter is obtained based on a data processing result in a wider range. This further improves data compression efficiency.

Optionally, in a possible implementation of the second aspect, the second network device obtains at least one training sample, where each training sample includes a string/an element in a training packet, and the element is an element in a coding character set; and the second network device obtains a quantity of repetition times of substrings or elements in the string, and obtains the first local compression parameter based on the quantity of repetition times of substrings or elements.

In this possible implementation, a local compression parameter is determined based on a quantity of repetition times of substrings or elements. This improves a compression ratio of a global compression parameter subsequently generated based on the quantity of repetition times.

Optionally, in a possible implementation of the second aspect, the second network device receives a first identifier sent by the first network device, where the first identifier identifies the first global compression parameter.

In this possible implementation, the identifier corresponding to the global compression parameter is received, so that the second network device can clarify each global compression parameter. Therefore, the global compression parameter is accurately used subsequently by using the identifier.

Optionally, in a possible implementation of the second aspect, if a preset condition is met, the second network device sends the first local compression parameter to the first network device, where the preset condition includes at least one of the following: a compression ratio of a second global compression parameter stored in the second network device is less than or equal to a first threshold; a quantity of packets or a byte length of a packet processed by the second network device is greater than or equal to a second threshold; and time of the second network device is a preset moment, or a time interval from a moment at which a local compression parameter is sent to the first network device last time reaches or exceeds a preset time period; and the second network device receives a synchronization request sent by the first network device, where the synchronization request is used to collect the first local compression parameter.

In this possible implementation, a condition for sending the local compression parameter is limited, so that the second network device can more clarify the condition for sending the local compression parameter. This improves processing efficiency of the second network device and efficiency of subsequently generating the global compression parameter by the first network device.

Optionally, in a possible implementation of the second aspect, the second network device obtains a compression policy, where the compression policy includes a synchronization policy and/or a retention policy, the synchronization policy is used by the second network device to generate and send a local compression parameter, and the retention policy indicates the second network device to store at least one global compression parameter before the first global compression parameter.

In this possible implementation, the first network device or an administrator may control the second network device according to the compression policy, so that the local compression parameter subsequently reported by the second network device and a quantity of stored global compression parameters meet a compression parameter synchronization requirement of the first network device.

Optionally, in a possible implementation of the second aspect, the synchronization policy includes a service type and a compression policy corresponding to the service type, and the service type and the compression policy corresponding to the service type indicate the second network device to process, according to the compression policy corresponding to the service type, a packet corresponding to the service type, and/or generate, according to the compression policy corresponding to the service type, a local compression parameter corresponding to the service type.

Optionally, in a possible implementation of the second aspect, the second network device communicates with the first network device based on a border gateway routing BGP message, and communication information includes one or more of the following: the synchronization request, the first local compression parameter, the first global compression parameter, or the compression policy.

Optionally, in a possible implementation of the second aspect, the first local compression parameter includes a first string, the second local compression parameter includes a second string, and the first global compression parameter includes a union set of the first string and the second string.

A third aspect of this application provides a first network device. The first network device includes an obtaining unit and a generation unit. The obtaining unit is configured to obtain a first local compression parameter and a second local compression parameter, where the first local compression parameter is generated by the first network device or a second network device, and the second local compression parameter is generated by a third network device. The generation unit is configured to generate a first global compression parameter based on the first local compression parameter and the second local compression parameter, where the first global compression parameter is for compression and decompression.

Optionally, in a possible implementation of the third aspect, the first network device further includes a sending unit; and the sending unit is configured to send a synchronization request to the second network device and/or the third network device to request the first local compression parameter and the second local compression parameter.

Optionally, in a possible implementation of the third aspect, the sending unit is further configured to send a first compression policy to the second network device and/or the third network device, where the first compression policy includes a synchronization policy and/or a retention policy, the synchronization policy is used by the second network device and/or the third network device to generate and send a local compression parameter, and the retention policy indicates the second network device and/or the third network device to store at least one global compression parameter before the first global compression parameter.

Optionally, in a possible implementation of the third aspect, the synchronization policy includes a service type and a compression policy corresponding to the service type, and the service type and the compression policy corresponding to the service type indicate the second network device and/or the third network device to process, according to the compression policy corresponding to the service type, a packet corresponding to the service type, and/or generate, according to the compression policy corresponding to the service type, a local compression parameter corresponding to the service type.

Optionally, in a possible implementation of the third aspect, the sending unit is configured to send the first global compression parameter to at least one network device, where the at least one network device includes one or more of the following network devices: the second network device or the third network device.

Optionally, in a possible implementation of the third aspect, the sending unit is further configured to send a first identifier to the at least one network device, where the first identifier identifies the first global compression parameter.

Optionally, in a possible implementation of the third aspect, the sending unit is specifically configured to communicate with the second network device and/or the third network device based on a border gateway routing BGP message, where communication information includes one or more of the following: the synchronization request, the first local compression parameter, the second local compression parameter, the first global compression parameter, or the first compression policy.

Optionally, in a possible implementation of the third aspect, the obtaining unit is further configured to obtain a second compression policy, where the second compression policy includes one or more of the following: a moment or a periodicity at which the first network device generates/sends the first global compression parameter, a moment or a periodicity at which the first network device sends the synchronization request, the service type and the compression policy corresponding to the service type, and a preset condition, where the preset condition indicates the first network device to send the first global compression parameter when the preset condition is met.

Optionally, in a possible implementation of the third aspect, the first local compression parameter, the second local compression parameter, and the first global compression parameter are dictionaries; and the first local compression parameter includes a first string, the second compression parameter includes a second string, and the first global compression parameter includes a union set of the first string and the second string.

Optionally, in a possible implementation of the third aspect, the first local compression parameter is a first local coding table, the second local compression parameter is a second local coding table, and the first global compression parameter is a first global coding table; the first local coding table includes a frequency or a quantity of times of a first element, the second local coding table includes a frequency or a quantity of times of a second element, and the first element and the second element are elements in a coding character set; and the generation unit is specifically configured to generate the first global coding table based on the frequency or the quantity of times of the first element and the frequency or the quantity of times of the second element, where the first global coding table includes elements in the coding character set and codeword corresponding to the elements.

Optionally, in a possible implementation of the third aspect, the obtaining unit is further configured to obtain a second global compression parameter; and the generation unit is specifically configured to generate the first global compression parameter based on the first local compression parameter, the second local compression parameter, and the second global compression parameter.

Optionally, in a possible implementation of the third aspect, the preset condition includes at least one of the following: time of the first network device is a preset moment, or a time interval from a moment at which a global compression parameter is sent to the at least one network device last time reaches or exceeds a preset time period; a variation amount of a quantity of occurrence times or an occurrence frequency of at least one element in the first global compression parameter is greater than or equal to a first threshold; a difference between a length of a string in the first global compression parameter and a length of a string in the second global compression parameter is greater than or equal to a second threshold; a ratio of a length of a string in the first global compression parameter to a length of a string in the second global compression parameter is greater than or equal to a third threshold; and in a process of generating the first global compression parameter based on the second global compression parameter, a quantity of times of adjusting a sequence of substrings or elements in the second global compression parameter is greater than or equal to a fourth threshold.

A fourth aspect of this application provides a second network device. The second network device includes an obtaining unit, a sending unit, a receiving unit, and a processing unit. The obtaining unit is configured to obtain a first local compression parameter. The sending unit is configured to send the first local compression parameter to a first network device. The receiving unit is configured to receive a first global compression parameter sent by the first network device, where the first global compression parameter is generated based on the first local compression parameter and a second local compression parameter. The processing unit is configured to compress/decompress target data based on the first global compression parameter, where the target data is data transmitted by the second network device.

Optionally, in a possible implementation of the fourth aspect, the obtaining unit is further configured to obtain at least one training sample, where each training sample includes a string/an element in a training packet, and the element is an element in a coding character set; and the obtaining unit is specifically configured to: obtain a quantity of repetition times of substrings or elements in the string; and obtain the first local compression parameter based on the quantity of repetition times of substrings or elements.

Optionally, in a possible implementation of the fourth aspect, the receiving unit is further configured to receive a first identifier sent by the first network device, where the first identifier identifies the first global compression parameter.

Optionally, in a possible implementation of the fourth aspect, the sending unit is specifically configured to: if a preset condition is met, send the first local compression parameter to the first network device; and the preset condition includes at least one of the following: a compression ratio of a second global compression parameter stored in the second network device is less than or equal to a first preset threshold; a quantity of packets or a byte length of a packet processed by the processing unit is greater than or equal to a second threshold, where the processing includes at least one of compression, receiving, and sending; and a local clock of the second network device is a preset moment, or a time interval from a moment at which a local compression parameter is sent to the first network device last time reaches or exceeds a preset time period; and the receiving unit receives a synchronization request sent by the first network device, where the synchronization request is used to collect the first local compression parameter.

Optionally, in a possible implementation of the fourth aspect, the obtaining unit is further configured to obtain a compression policy, where the compression policy includes a synchronization policy and/or a retention policy, the synchronization policy is used by the second network device to generate and send a local compression parameter, and the retention policy indicates the second network device to store at least one global compression parameter before the first global compression parameter.

Optionally, in a possible implementation of the fourth aspect, the synchronization policy includes a service type and a compression policy corresponding to the service type, and the service type and the compression policy corresponding to the service type indicate the second network device to process, according to the compression policy corresponding to the service type, a packet corresponding to the service type, and/or generate, according to the compression policy corresponding to the service type, a local compression parameter corresponding to the service type.

Optionally, in a possible implementation of the fourth aspect, the sending unit is specifically configured to communicate with the first network device based on a border gateway routing BGP message, and communication information includes one or more of the following: the synchronization request, the first local compression parameter, the first global compression parameter, or the compression policy.

Optionally, in a possible implementation of the fourth aspect, the first local compression parameter includes a first string, the second local compression parameter includes a second string, and the first global compression parameter includes a union set of the first string and the second string.

A fifth aspect of this application provides a first network device, including a processor. The processor is coupled to a storage. The storage is configured to store a program or instructions. When the program or the instructions are executed by the processor, the first network device is enabled to implement the method in any one of the first aspect or the possible implementations of the first aspect.

A sixth aspect of this application provides a second network device, including a processor. The processor is coupled to a storage. The storage is configured to store a program or instructions. When the program or the instructions are executed by the processor, the second network device is enabled to implement the method in any one of the second aspect or the possible implementations of the second aspect.

A seventh aspect of this application provides a communication system. The communication system includes the first network device in the fifth aspect and/or the second network device in the sixth aspect.

An eighth aspect of this application provides a computer-readable storage medium. The computer-readable storage medium stores instructions. When the instructions are executed on a computer, the computer is enabled to perform the method in any one of the first aspect or the possible implementations of the first aspect, or the method in any one of the second aspect or the possible implementations of the second aspect.

A ninth aspect of this application provides a computer program product. When the computer program product is executed on a computer, the computer is enabled to perform the method in any one of the first aspect or the possible implementations of the first aspect, or the method in any one of the second aspect or the possible implementations of the second aspect.

### BRIEF DESCRIPTION OF DRAWINGS

FIG. 1 is a diagram of an application scenario according to an embodiment of this application;
FIG. 2 is a schematic flowchart of a dictionary compression method according to an embodiment of this application;
FIG. 3 is a diagram of a structure of a network device according to an embodiment of this application;
FIG. 4 is a schematic flowchart of a data processing method according to an embodiment of this application;
FIG. 5 is a diagram of several examples of dictionary distillation according to an embodiment of this application;
FIG. 6 is a diagram of common BGP message types according to an embodiment of this application;
FIG. 7 is a diagram of an example of a BGP message format according to an embodiment of this application;
FIG. 8 is a diagram of communication between a control device and a network device by using a publish-subscribe mechanism according to an embodiment of this application;
FIG. 9 is a diagram of sending, by a control device, a synchronization request to each network device in a network scenario according to an embodiment of this application;
FIG. 10 is a schematic flowchart of generating different service local dictionaries by different network devices according to an embodiment of this application;
FIG. 11 is a schematic flowchart of delivering different service global dictionaries by a control device to different network devices according to an embodiment of this application;
FIG. 12 is a schematic flowchart of delivering a first compression policy in a network scenario according to an embodiment of this application;
FIG. 13 is a schematic flowchart of applying a compression policy by a network device according to an embodiment of this application;
FIG. 14 is another schematic flowchart of a data processing method according to an embodiment of this application;
FIG. 15 is a diagram of an example of updating a locally stored global dictionary by a network device according to an embodiment of this application;
FIG. 16 is a diagram of a structure of a first network device according to an embodiment of this application;
FIG. 17 is a diagram of a structure of a second network device according to an embodiment of this application; and
FIG. 18 is a diagram of another structure of a network device according to an embodiment of this application.

### DESCRIPTION OF EMBODIMENTS

To make objectives, technical solutions, and advantages of this application clearer, the following further describes implementations of this application in detail with reference to accompanying drawings.

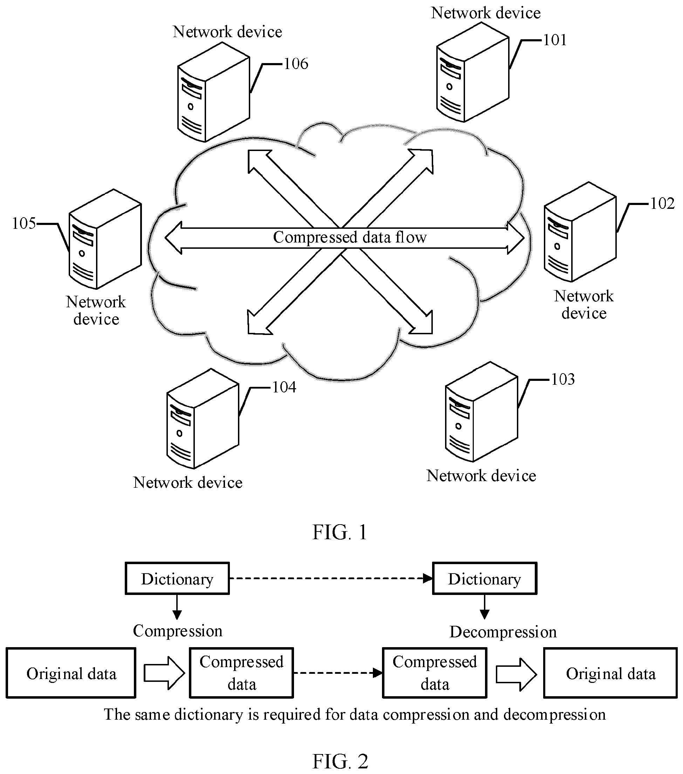

FIG. 1 is a diagram of an application scenario according to an embodiment of this application. As shown in FIG. 1, the application scenario includes network devices 101 to 106. Any two of the network devices 101 to 106 may communicate with each other.

Optionally, the network devices 101 to 106 may be separately configured to connect to a local network, for example, a data center network (Data Center network, DCN), a campus network, or a metropolitan area network. For example, the network device 101 and the network device 104 are ingress devices of a data center 1 and a data center 2 respectively. The data center 1 communicates with another device/network via the network device 101, and the data center 2 communicates with another device/network via the network device 104.

The network device in embodiments of this application may be a plurality of devices, for example, a device mainly for routing/forwarding, like a router or a switch (for example, a frame-shaped switch or a switch in a form of a pluggable card), or a device like a cloud server, a gateway, or a firewall. This is not specifically limited herein.

A large amount of data needs to be transmitted between a local network and another network. To reduce bandwidth requirements of ingress devices (for example, the network device 101 and the network device 104) of local networks or an amount of data transmitted in networks, before the data is transmitted between the ingress devices of different local networks, the data may be compressed to reduce the amount of the to-be-transmitted data. For example, before sending data, a network device compresses the to-be-transmitted data (original data). To ensure consistency between a compression parameter (for example, a dictionary or a coding table) and a decompression parameter, before the data is transmitted, the network device that sends the data and a network device that receives the data synchronize the compression parameter and the decompression parameter. For example, as shown in FIG. 2, a network device that sends data and a network device that receives the data synchronize a dictionary for compression and decompression. The network device that sends the data compresses the original data by using the dictionary, to obtain target data, and sends the target data to the network device that receives the data. The network device that receives the data decompresses the target data by using the same dictionary, to obtain the original data.

To improve data compression efficiency, the network device may update the compression parameter based on historically processed data. Once one network device updates a compression parameter, another network device communicating with the network device also needs to update a locally stored compression parameter, to ensure that compressed data received from the network device can be decompressed. Each network device in a network may update a compression parameter. As a result, each network device in the network needs to synchronize the compression parameter with any other network device, to locally maintain a latest compression parameter for each other network device. This results in high complexity of maintaining the compression parameter between network devices, and each network device further needs to store a plurality of compression parameters.

In view of this, embodiments of this application provide a data processing method and a related device. In the method, at least two network devices in a plurality of network devices generate local compression parameters based on processed historical data. A control device obtains the local compression parameters from the at least two network devices, generates a global compression parameter based on the local compression parameters from the at least two network devices, and then sends the global compression parameter to each network device. Each network device compresses and decompresses data based on the received global compression parameter. The at least two network devices may generate new local compression parameters periodically. The control device may further update the global compression parameter based on the new local compression parameters and send a new global compression parameter to each network device. In this way, each network device only needs to maintain a few global compression parameters (for example, one global compression parameter), and each network device needs to synchronize only the compression parameters with the control device, thereby reducing complexity of maintaining the compression parameter. In addition, the control device updates a global compression parameter based on local compression parameters generated by the plurality of network devices, so that the global compression parameter is obtained based on a data processing result in a wider range. This further improves data compression efficiency.

Optionally, the control device may be a device independent of the network device. For example, the control device is a network management device in a network, and the plurality of network devices are the network devices 101 to 106 shown in FIG. 1. The network management device receives local compression parameters sent by at least two network devices in the network devices 101 to 106, generates/updates a global compression parameter based on the received local compression parameters, and sends the global compression parameter to the at least two network devices.

Optionally, the control device may alternatively be one of the plurality of network devices. For example, the control device is the network device 101 shown in FIG. 1. The network device 101 receives a local compression parameter from at least one network device in the network devices 102 to 106, generates or updates a global compression parameter based on the received local compression parameter and a local compression parameter generated by the network device 101, and sends the global compression parameter to the at least one network device.

Optionally, the control device may alternatively send the global compression parameter to another network device. For example, the control device sends the global compression parameter to a network device other than the at least two network devices in the network devices 101 to 106, or sends the global compression parameter to a network device other than the at least one network device, or sends the global compression parameter to a network device in another network scenario, so that the another network device can also perform compression and decompression based on the global compression parameter.

The compression parameter is used by a data transmitting end to compress original data to obtain compressed data, and is also used by a data receiving end to decompress the compressed data to obtain the original data. Optionally, the compression parameter includes a dictionary and/or a coding table.

The dictionary in embodiments of this application includes a string. The string is used to compress or decompress data. For example, when a string in a to-be-transmitted packet is consistent with a substring in a dictionary, a network device at a transmitting end may use a start location of the substring in the dictionary and a length of the substring to represent the string in the to-be-transmitted packet. The to-be-transmitted packet is compressed based on the dictionary, so that a small quantity of bits can represent a symbol that appears more frequently. A network device at a receiving end may query the dictionary based on a start location of each substring carried in the compressed packet in the dictionary and a length of the substring to restore the substring, so as to decompress the received compressed packet.

In embodiments of this application, the coding table for encoding and decoding includes an element and codeword corresponding to the element. The network device at the transmitting end may encode, by using entropy encoding (for example, Huffman encoding, arithmetic encoding, or Shannon encoding), an element used at a high frequency into codeword with a short length, to reduce a data transmission amount. The network device at the receiving end restores original data based on the coding table.

The following describes in detail the data processing method and the related device provided in embodiments of this application with reference to the accompanying drawings.

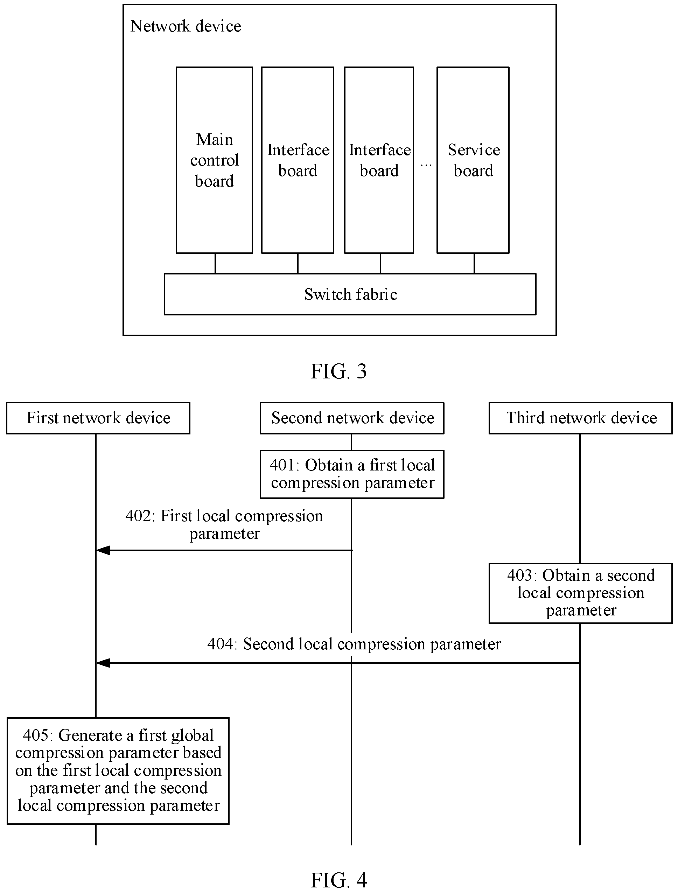

FIG. 3 is a diagram of a structure of a network device according to an embodiment of this application. The network device includes a switch fabric, a main control board, interface boards, and a service board.

The switch fabric is mainly for internal data exchange of the network device, and may also be understood as being used to transmit service data. The switch fabric is mainly responsible for data forwarding and switching across interface boards, and is responsible for functions such as packet switching, distribution, scheduling, and control between interface boards. Generally, the switch fabric uses high-performance application-specific integrated circuit (Application-Specific Integrated Circuit, ASIC) chip to provide line-rate forwarding.

The main control board is mainly for providing a management and control function of the network device and a protocol processing function of a data plane. As an agent of a user operation, the main control board manages a system and monitors performance according to user's operation instruction, and reports a running status of the network device to a user, for example, delivers a configuration policy and monitors and maintains an interface board, a fans, and a power supply.

The interface board is mainly for providing an external physical interface for service transmission and receiving/sending service data, for example, executing an access control list (Access Control List, ACL) policy. In addition, there may be one or more interface boards, and a quantity of the interface boards may be set based on a specific requirement. This is not limited herein.

The service board is mainly for performing processing on service data, and the processing includes, for example, compression, decompression, encryption, and decryption.

In a possible implementation, the network device shown in FIG. 3 is the foregoing control device. The interface board in FIG. 3 is further configured to: receive local compression parameters sent by at least two network devices, send the local compression parameters to the service board through the switch fabric, and the like. The service board is further configured to: receive the local compression parameters sent by the interface board through the switch fabric, generate a global compression parameter based on the local compression parameters from the at least two network devices, and send the global compression parameter to each network device through the switch fabric and the interface board. The global compression parameter is used by each network device to compress and decompress data.

In another possible implementation, the network device shown in FIG. 3 is the foregoing network device that generates the local compression parameter. The service board in FIG. 3 is further configured to: generate a local compression parameter based on processed data, send the local compression parameter to a control device through the switch fabric and the interface board, receive, through the switch fabric and the interface board, a global compression parameter sent by the control device, use the global compression parameter to compress/decompress transmitted service data, and the like.

In the hardware structure shown in FIG. 3, the service board in the network device (the network device that generates the local compression parameter) may only need to maintain a few global compression parameters (for example, one global compression parameter), and a service board in each network device only needs to synchronize the compression parameters with the control device, thereby reducing complexity of maintaining the compression parameter by the service board.

The following describes the data processing method in embodiments of this application. As shown in FIG. 4, the data processing method may include step 401 to step 405. In the method, a first network device obtains a plurality of local compression parameters, and generates a global compression parameter based on the plurality of local compression parameters. The plurality of local compression parameters may be generated by a plurality of other network devices. For example, the plurality of other network devices include a second network device and a third network device. After the first network device generates the global compression parameter, the first network device sends the global compression parameter to the plurality of other network devices, so that the plurality of other network devices compress/decompress data by using the global compression parameter.

Step 401: The second network device obtains a first local compression parameter.

The second network device is, for example, any one of the network devices 101 to 106 shown in FIG. 1.

The second network device obtains at least one training packet, and obtains the first local compression parameter based on the at least one training packet. The second network device may collect statistics on a quantity of occurrence times of a string/element in each training packet, and then generate the first local compression parameter based on the occurred string/element. The first local compression parameter includes the occurred string or element. The first local compression parameter may further include a quantity of occurrence times of each string or element. That the second network obtains the first local compression parameter based on the at least one training packet may be obtaining the first local compression parameter based on a load of each training packet. For example, the second network device collects statistics on strings that occur in loads of training packets one by one and a quantity of times that each string repeatedly occurs.

The second network device may obtain a training packet in a plurality of manners. For example, the at least one training packet may be a packet transmitted by the second network device, or the at least one training packet is a packet generated by the second network device, or the at least one training packet is a packet obtained by the second network device from a cloud server. This is not specifically limited herein.

A compression parameter in this application may be a dictionary, a coding table, and/or the like. Based on different compression parameters, manners in which the second network device obtains the first local compression parameter based on the at least one training packet are different. The following separately describes the manners.

In a first manner, the first local compression parameter is a first local dictionary.

In this case, the second network device extracts substrings that occur in the training packet and quantities of occurrence times of the substrings. For example, the second network device searches a payload of the training packet for the substrings by using a substring search algorithm (for example, substring search or a suffix array), and determines the quantities of occurrence times of the substrings.

After obtaining the substrings and the quantities of times of the substrings, the second network device sorts the substrings in descending order based on the quantities of occurrence times of the substrings, and then performs combination processing on the substrings to obtain the first local dictionary. The combination processing may include at least one of the following: comma-separated value (Comma-Separated Value, CSV) processing (namely, separation based on a comma), semicolon-separated processing (namely, separation based on a semicolon), and the like. This is not specifically limited herein.

Optionally, the second network device extracts quantities of repetition times of substrings in each string, and organizes the substrings in descending order of the quantities of repetition times, to obtain dictionary content of the first local dictionary. For example, the second network device generates the first local dictionary by using a ZSTD (Zstandard) dictionary training algorithm.

For example, a first string of the first local dictionary includes two substrings: "abc" and "01234". In addition, a quantity of occurrence times of the substring "abc" in a plurality of training packets is greater than a quantity of occurrence times of the substring "01234" in the plurality of training packets. Content of the first local dictionary is "abc, 01234". In this example, the foregoing CSV processing is for separation processing.

Further, the second network device may further record quantities of repetition times of the substrings, and store the quantities of repetition times of substrings in the first local dictionary.

In a second manner, the first local compression parameter is a first local coding table.

In this case, the second network device obtains, based on a coding manner of a training packet (for example, a unicode transformation format (Universal Character Set/Unicode Transformation Format, UTF8) or American standard code for information interchange (ASICII) coding), coding character set elements corresponding to the coding manner, and collects statistics on quantities of occurrence times of the elements in the training packet. The first local coding table includes the elements that occur in the training packet and the quantities of occurrence times of the elements. It may be understood that the quantities of occurrence times of the elements may be replaced with another values, for example, occurrence frequencies and total quantities of occurrence times of the elements.

Step 402: The second network device sends the first local compression parameter to the first network device. Correspondingly, the first network device receives the first local compression parameter sent by the second network device.

After obtaining the first local compression parameter, the second network device may send the first local compression parameter to the first network device. Correspondingly, the first network device receives the first local compression parameter sent by the second network device.

Optionally, to reduce a transmission amount of the first local compression parameter, the second network device may further perform encoding processing on the first local compression parameter, and send, to the first network device, the first local compression parameter obtained by the encoding processing. The encoding processing may include entropy encoding (for example, Huffman encoding, arithmetic encoding, or Shannon encoding) processing, and the like. This is not specifically limited herein. The entropy encoding processing is used as an example. The second network device may perform encoding processing on the first local dictionary by using a prestored entropy encoding table.

Optionally, to clarify an occasion at which the second network device sends the first local compression parameter, there may be a trigger condition in step 402, that is, if a preset condition is met, the second network device sends the first local compression parameter to the first network device. To distinguish a trigger condition for subsequently sending the global compression parameter by the first network device, the preset condition for sending the first local compression parameter by the second network device is subsequently referred to as a first preset condition, and a preset condition for sending the global compression parameter by the first network device is referred to as a second preset condition. In addition, trigger conditions for sending local compression parameters by a plurality of network devices are similar. To distinguish the first network device from other network devices, the following uses a control device to replace the first network device, and uses network devices to replace the second network device and the subsequent third network device.

The first preset condition may include at least one of the following:
1. A compression ratio of a second global compression parameter stored in the network device is less than or equal to a first preset threshold, where the second global compression parameter is a compression parameter locally stored in the network device. The second global compression parameter may be an initial compression parameter preconfigured by the network device, or may be a global compression parameter obtained from the control device before the first local compression parameter is sent. This case may be understood as an example in which deterioration of the compression ratio is used as the trigger condition.
2. A quantity of packets or a byte length of a packet processed by the network device is greater than or equal to a second preset threshold, where the processing includes at least one of compression, receiving, sending, and the like. This case may be understood as an example in which the first preset condition includes a quantitative trigger condition.
3. A local clock of the network device is a first preset moment, or a time interval from a moment at which a local compression parameter is sent to the control device last time reaches or exceeds a first preset time period. This case may be understood as an example in which the first preset condition includes a timing/periodic trigger condition.
4. A synchronization request sent by the control device is received, where the synchronization request is used to obtain the first local compression parameter. For a related description of the synchronization request, refer to a subsequent description of sending the synchronization request by the control device to the network device. Details are not described herein again.

It may be understood that the foregoing several cases of the first preset condition are merely examples. In actual application, the first preset condition may further have another case. This is not specifically limited herein.

Step 403: The third network device obtains a second local compression parameter.

The third network device is, for example, a network device other than the second network device in the network devices 101 to 106 shown in FIG. 1.

A description of obtaining, by the third network device, the second local compression parameter is similar to that in a manner of obtaining, by the second network device, the first local compression parameter in step 401, and details are not described herein again.

For example, the second local compression parameter is a second local dictionary, and content of the second local dictionary is a second string: "abcde, 012".

Step 404: The third network device sends the second local compression parameter to the first network device. Correspondingly, the first network device receives the second local compression parameter sent by the third network device.

After obtaining the second local compression parameter, the third network device may send the second local compression parameter to the control device.

Optionally, this is similar to the description of sending, by the second network device, the first local compression parameter to the control device in step 402. In one aspect, to reduce a transmission amount of the second local compression parameter, the third network device may encode the second local compression parameter, and send, to the control device, the second local compression parameter after encoding. In another aspect, to clarify an occasion at which the third network device sends the second local compression parameter, there may also be a trigger condition in step 404, that is, if a first preset condition is met, the third network device sends the second local compression parameter to the control device. For the first preset condition, refer to the description in step 402. Details are not described herein again.

Step 405: The first network device generates the first global compression parameter based on the first local compression parameter and the second local compression parameter.

After obtaining the first local compression parameter and the second local compression parameter, the control device may generate the first global compression parameter based on the first local compression parameter and the second local compression parameter. The first global compression parameter is for compression and decompression.

A compression parameter may be a dictionary, a coding table, or the like. Based on different compression parameters, a manner in which the control device generates the first global compression parameter based on the first local compression parameter and the second local compression parameter is different. The following separately describes the manners.

In a first manner, the first local compression parameter is a first local dictionary, the second local compression parameter is a second local dictionary, and the first global compression parameter is a first global dictionary.

In this case, the control device obtains a union set of substrings in the first local dictionary and substrings in the second local dictionary to obtain the first global dictionary. Obtaining the union set may be understood as traversing each substring in the second local dictionary by using each substring in the first local dictionary to find an inclusion relationship. If a substring including the substring is found in the second local dictionary, the substring found in the second local dictionary is used as a substring in the first global dictionary. If no substring including the substring is found in the second local dictionary or a subset of the substring is found in the second local dictionary, the substring in the first local dictionary is used as a substring in the first global dictionary. For a substring that is in the second local dictionary and is irrelevant to the first local dictionary (for example, a substring that is not a substring in the substrings in the first local dictionary and that does not include a substring in the first local dictionary), the string may be directly added to the global dictionary.

For example, the foregoing examples of the first local dictionary and the second local dictionary are continued. The content of the first local dictionary is the first string "abc, 01234", and the content of the second local dictionary is the second string "abcde, 012". Through the foregoing processing of obtaining the union set, the substring abcde including the substring abc is found in substrings in the second local dictionary by using the substring abc, and substrings in the first global dictionary include the substring abcde. The substring 012 is found in the substrings in the second local dictionary by using the substring 01234 to be a subset of the substring 01234 in the first local dictionary, and the substrings in the first global dictionary further include the substring 01234. That is, the first global dictionary includes "abcde01234" or "01234abcde".

Further, to improve subsequent compression efficiency of the first global dictionary, when obtaining the first local dictionary, the second network device may further obtain the quantities of occurrence times of the substrings in the first local dictionary, and report the quantities of times to the control device. Similarly, when obtaining the second local dictionary, the third network device may further obtain the quantities of occurrence times of the substrings in the second local dictionary, and report the quantities of times to the control device. After obtaining quantities of occurrence times of the substrings, the control device may sort the substrings based on the quantities of times of the substrings, to obtain the first global dictionary.

For example, the foregoing example is continued. The first global dictionary includes two substrings: "abcde" and "01234". A quantity of times of the substring "01234" in the first local dictionary reported by the second network device is 1000, and a quantity of times of the substring "abcde" in the second local dictionary reported by the third network device is 2000. In this case, in descending order of times, the string included in the first global dictionary may be specifically "abcde01234". In this way, a substring of "abcde" (for example, "abc") or the substring "abcde" that occurs more frequently may correspond to a smaller location index, and a smaller location index may correspond to a smaller data transmission amount.

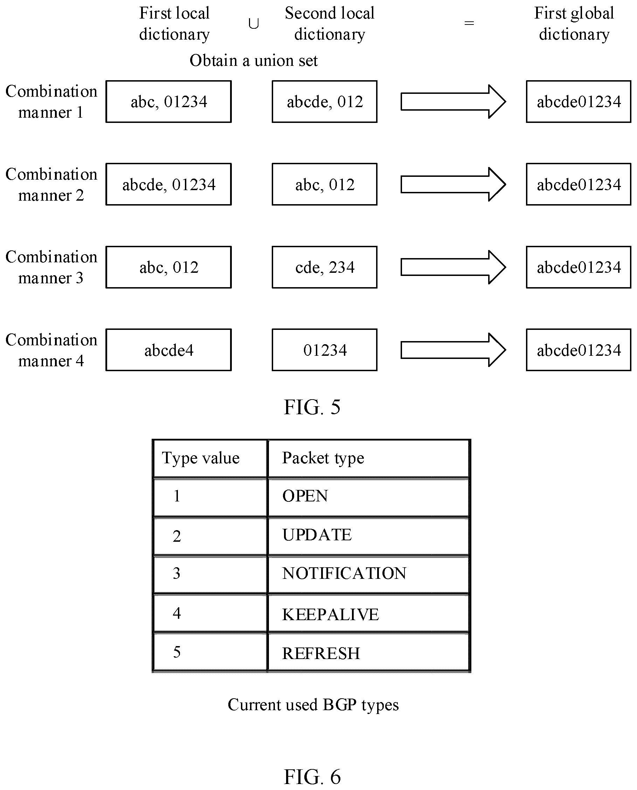

For example, FIG. 5 shows several examples in which the control device generates the first global dictionary (this process may be referred to as dictionary distillation) based on the first local dictionary and the second local dictionary. The control device obtains the first global dictionary by obtaining the union set of the first local dictionary and the second local dictionary. For example, in a combination manner 1, if the first local dictionary includes "abc, 01234", and the second local dictionary includes "abcde, 012", the first global dictionary obtained by obtaining the union set includes "abcde01234". For another example, in a combination manner 2, if the first local dictionary includes "abcde, 01234", and the second local dictionary includes "abc, 012", the first global dictionary obtained by obtaining the union set includes "abcde01234". For another example, in a combination manner 3, if the first local dictionary includes "abc, 012", and the second local dictionary includes "cde, 234", the first global dictionary obtained by obtaining the union set includes "abcde01234". For another example, in a combination manner 4, if the first local dictionary includes "abcde", and the second local dictionary includes "01234", the first global dictionary obtained by obtaining the union set includes "abcde01234". It may be understood that the combination manners and the manner of obtaining the global dictionary by obtaining the union set shown in FIG. 5 are merely examples.

It may be understood that the foregoing several cases of generating the first global dictionary are merely examples. In actual application, there may be another manner. For example, the control device may select a part from the first local dictionary and a part from the second local dictionary according to a rule, and combine the two selected parts into the first global dictionary. This is not specifically limited herein. The rule may include that the control device selects a substring whose quantity of times is greater than or equal to a threshold in the local dictionary. If a length of the first global dictionary is greater than or equal to a length threshold, the control device may delete, from the first global dictionary, a substring whose quantity of times is less than a threshold, or the control device may delete, from the local dictionary, a substring whose quantity of characters is less than a threshold, and then regenerate the first global dictionary by using a local dictionary after the substring is deleted.

For example, at a moment T, the control device receives a local dictionary 1 and a local dictionary 2 that are reported by network devices. Content of the local dictionary 1 is a substring 1 and a substring 2. Content of the local dictionary 2 is a substring 1 and a substring 3. The control device generates a global dictionary 1 based on the local dictionary 1 and the local dictionary 2, where content of the global dictionary 1 is the substring 1, the substring 2, and the substring 3. At a moment T+t (t>0), the control device receives a local dictionary 3 and a local dictionary 4 that are reported by network devices. Content of the local dictionary 3 is a substring 2 and a substring 4. Content of the local dictionary 4 is a substring 3 and a substring 4. The control device may generate a global dictionary 2 based on the local dictionary 3, the local dictionary 4, and the global dictionary 1, where content of the global dictionary 2 is the substring 2, the substring 3, and the substring 4. Therefore, the substring 1 is removed from the global dictionary 2, and the substring 4 is included in the global dictionary 2. This effectively improves compression effect of each network device at a subsequent moment while maintaining a scale of the global dictionary and ensuring dictionary search and traversal efficiency.

It may be understood that the control device may generate or update a global dictionary based on more local dictionaries. For example, the control device receives a first local dictionary, a second local dictionary, and a third local dictionary. The control device first generates an intermediate dictionary based on the first local dictionary and the second local dictionary, and then generates a first global dictionary based on the intermediate dictionary and the third local dictionary. A manner of generating the first global dictionary based on the intermediate dictionary and the third global dictionary is similar to that in the foregoing description about generating the first global dictionary based on the first local dictionary and the second local dictionary.

In a second manner, the first local compression parameter is a first local coding table, the second local compression parameter is a second local coding table, and the first global compression parameter is a first global coding table.

In this case, the control device generates the first global coding table based on the elements in the local coding tables and the quantities of occurrence times of the elements, where the first global coding table includes the elements in the foregoing coding character sets and codeword corresponding to the elements. For any element in the coding character sets, the control device accumulates quantities of occurrence times of the element in the local coding tables, to obtain a total quantity of occurrence times of the element, and then generates codeword corresponding to each element based on the total quantity of occurrence times or an occurrence frequency of each element. For example, the control device generates the codeword corresponding to each element based on Huffman encoding, arithmetic encoding, or the like. For an element that occurs in each local coding table, the control device may set a quantity of occurrence times of the element to 0.

Optionally, if the control device previously stores the second global compression parameter, the control device may update the second global compression parameter based on the first local compression parameter and the second local compression parameter, to obtain the first global compression parameter.

When the compression parameter is a dictionary, the second global compression parameter includes a string, and the local compression parameters include a plurality of substrings. The control device uses a substring for matching in the string, and if the matching fails, adds the substring to the second global compression parameter. If the matching succeeds, the control device may further adjust a sequence of the strings in the global compression parameter based on the quantities of occurrence times of the substrings. If the matching fails, the control device may place the substring at the front of a string to obtain the first global compression parameter, or adjust, based on the quantities of occurrence times of the substrings, a sequence that the substrings occur in a string, and place, at the front of the string, a substring that occurs more times. If the first global compression parameter has a length limit, the control device may further delete, based on a requirement, a substring that occurs less times, for example, delete an end substring in the string. The foregoing process of updating the second global compression parameter includes that the control device adds a first substring based on the second global dictionary, the control device deletes a second substring, and the control device adjusts the sequence of the substrings that occur in the second global dictionary. The first substring is a string added to the first local dictionary and the second local dictionary relative to the second global dictionary, and the second substring is a substring greater than a preset length. If the network device further reports, to the control device, a quantity of occurrence times of a substring, the second substring may alternatively be a substring whose quantity of occurrence times is less than a threshold.

When the compression parameter is a coding table, the control device updates, based on elements in local coding tables and quantities of occurrence times of the elements, quantities of occurrence times of elements in the second global coding table, and generates, based on updated quantities of occurrence times of elements, codeword corresponding to the elements, to obtain the first global coding table.

Further, after generating the first global compression parameter, the control device may send the first global compression parameter to the at least one network device, so that the at least one network device transmits data by using the first global compression parameter. The at least one network device may include one or more of the following network devices: the second network device, the third network device, and another network device (for example, a network device other than the second network device and the third network device in the application scenario shown in FIG. 1, or a network device in another application scenario).

Optionally, there may be a trigger condition for the control device to send the first global compression parameter to the at least one network device, that is, if the second preset condition is met, the control device sends the first global compression parameter to the at least one network device.

The second preset condition may include at least one of the following:
1. Time of the control device is a second preset moment, or a time interval from a moment at which a global compression parameter is sent to the at least one network device last time reaches or exceeds a second preset time period. This case may be understood as an example in which the second preset condition includes a timing/periodic trigger condition.
2. A variation amount of a quantity of occurrence times or an occurrence frequency of at least one element in the first global compression parameter is greater than or equal to a first threshold.
3. A difference between a length of a string in the first global compression parameter and a length of a string in the second global compression parameter is greater than or equal to a second threshold.
4. In a process in which the control device generates the first global compression parameter based on the second global compression parameter, a quantity of times of adjusting the sequence of substrings or elements in the second global compression parameter is greater than or equal to a third threshold. For example, if a quantity of times of a substring/element recorded in the second global compression parameter is 100, and a quantity of times of adding the substring/element reported by the local compression parameter is 200, a quantity of occurrence times of the substring/element in the first global compression parameter is 300. If the quantity of times of the substring/element in strings/all elements in the second global compression parameter exceeds that of another substring/element, the substring/element occurring 300 times is moved forward. The control device may compare a relative location of each substring or element in the first global compression parameter with a relative location of each substring or element in the second global compression parameter. If relative locations of a substring or element change, the quantity of times of adjusting the sequence of the substrings or elements in the second global compression parameter is incremented by 1. For example, it is assumed that the second global compression parameter is a coding table, relative locations of the elements in the coding table are A, B, C, D, and E, and relative locations of the elements in the first global compression parameter are B, C, D, E, and A. Relative locations of the elements change. In this case, the quantity of times of adjusting the sequence of the elements in the second global compression parameter is 5. For another example, it is assumed that the second global compression parameter is a second global dictionary, the string included in the second global dictionary is ABCabcDEFdef, and the string included in the first global dictionary is abcDEFdefABC. Relative locations of all the substrings change. In this case, the quantity of times of adjusting the sequence of the substrings in the second global compression parameter is 4.

It may be understood that the foregoing several cases are merely examples. In actual application, the second preset condition may further have another case. This is not specifically limited herein.

It should be noted that a quantity of occurrence times of each substring or element in a local compression parameter reported by each network device may be a total quantity of occurrence times of each substring or element (for example, a quantity of times, of an element in the training packet, counted by the network device from starting running of network device to each reporting), or may be a variation amount of a quantity of occurrence times of each substring or element (for example, a quantity of occurrence times of an element in the training packet, counted by the network device from last reporting to this reporting).

In this embodiment of this application, a time sequence between steps is not limited. For example, there is no time sequence limit between step 401 and step 403/step 404, and there is no time sequence limit between step 402 and step 403/step 404. For example, step 401 and step 402 may be performed after step 403, or may be performed after step 404. For another example, step 402 may be performed after step 404. This is not specifically limited herein.

In addition, step 401 to step 405 may be repeatedly performed, and a quantity of times of repeated execution may be set based on an actual requirement. For example, step 401 to step 405 are periodically performed. The network device may compress a to-be-transmitted packet based on the received global compression parameter, and continue to count the substrings or elements that occur in each to-be-transmitted packet and quantities of occurrence times of the substrings or elements, so as to generate a new local compression parameter.

In this embodiment of this application, the first network device obtains the plurality of local compression parameters, and generates the global compression parameter based on the plurality of local compression parameters. The plurality of local compression parameters may be generated by the plurality of other network devices. For example, the plurality of other network devices include the second network device and the third network device. The global compression parameter is for compression or decompression. In this way, the network device only needs to maintain a few global compression parameters (for example, one global compression parameter), and the network device needs to synchronize only the compression parameters with the first network device, thereby reducing complexity of maintaining the compression parameter. In addition, the first network device updates the global compression parameter based on the local compression parameters generated by the plurality of other network devices, so that the global compression parameter is obtained based on a data processing result in a wider range. This further improves data compression efficiency.

Optionally, the first network device and the second network device are a same network device, and the at least one network device includes the third network device. In this case, the embodiment shown in FIG. 4 may be understood as interaction between two network devices. The data processing method shown in FIG. 4 may include: The first network device generates the first local compression parameter, receives the second local compression parameter sent by the third network device, generates the first global compression parameter based on the first local compression parameter and the second local compression parameter, and sends the first global compression parameter to the third network device. In this solution, the first network device and the third network device can compress/decompress target data based on the first global compression parameter, and the target data is data transmitted between the first network device and the third network device.

Optionally, the at least one network device includes the second network device and the third network device. In this case, the network device that reports the local compression parameter receives the global compression parameter, and compresses/decompresses, based on the global compression parameter, the data transmitted by the network device. The embodiment shown in FIG. 4 may be understood as interaction between three network devices. The data processing method shown in FIG. 4 may include: The second network device generates the first local compression parameter, the third network device generates the second local compression parameter, the first network device receives the first local compression parameter sent by the second network device and the second local compression parameter sent by the third network device, the first network device generates the first global compression parameter based on the first local compression parameter and the second local compression parameter, and the first network device sends the first global compression parameter to the second network device and the third network device. In this solution, the second network device and the third network device can compress/decompress target data based on the first global compression parameter, and the target data is data transmitted between the second network device and the third network device. Alternatively, it is understood that the second network device and the third network device not only serve as "collectors" of the local compression parameters, but also serve as "users" of the global compression parameter.

Optionally, the at least one network device may be at least one of the network devices 101 to 106 shown in FIG. 1 except the first network device, the second network device, and the third network device.

In this case, it may be understood that the global compression parameter generated based on the local compression parameters reported by the second network device and the third network device may be used in another scenario. For example, the global compression parameter is provided for other network devices with similar service interaction.

It may be understood that the foregoing several cases are merely several descriptions of relationships between the network devices. In actual application, there may be another case of the relationship between the network devices. This is not specifically limited herein.

Optionally, the first network device may be a device independent of a network device. For example, the first network device is a network management device in a network. Alternatively, the first network device may be any one of the network devices 102 to 106 shown in FIG. 1. The network device may elect a network device as the first network device according to an election rule. For example, if the first network device is any network device in the network scenario shown in FIG. 1, the first network device may be a network device with a largest or smallest identifier number in the network scenario shown in FIG. 1. The identifier number may include a MAC address identifier, a parameter value related to device hardware, and the like. The parameter value includes at least one of a quantity of processors, a quantity of cores, a cache size, cache levels, a memory size, a product serial number, and the like in the network device.

For example, in the network scenario, a network device with a largest quantity of processors is selected as the first network device. For another example, each network device in the network scenario may elect, in a broadcast manner, a device with a largest identifier number as the first network device. Certainly, to ensure that a compression parameter synchronization process in the network scenario is not affected when the first network device is abnormal, a network device with a second largest identifier number may also be used as a candidate device of the first network device.

In this embodiment of this application, the control device (for example, the first network device) and the network device (for example, the second network device and/or the third network device) may exchange data in a plurality of manners (or according to communication rules). The following separately describes the manners.

In a first manner, the control device and the network device communicate with each other by using an extended border gateway routing protocol (Border Gateway Protocol, BGP).

In this case, the control device and the network device first establish a BGP session, and are peers (peers) to each other, so that a BGP message can be sent to each other. Existing BGP message types include 1 to 5, and are used to update a route between peers. As shown in FIG. 6, a packet type of a BGP message with a type value 1 is OPEN, a packet type of a BGP message with a type value 2 is UPDATE, a packet type of a BGP message with a type value 3 is NOTIFICATION, a packet type of a BGP message with a type value 4 is KEEPALIVE, and a packet type of a BGP message with a type value 5 is REFRESH.

In this embodiment of this application, a new packet type is defined to extend BGP, so as to synchronize the compression parameter between the control device and the network devices. For example, in this embodiment of this application, at least one of the following four packet types (6, 7, 8, and 9) is newly added.

A BGP message with a type value 6 is used by the control device to send a synchronization request to the network device, where the synchronization request is used to obtain the local compression parameter. For example, the control device in the embodiment shown in FIG. 3 may request the local compression parameter from the network device by sending the BGP message with the type value 6 to the network device. The following describes the synchronization request in detail, and details are not described herein again.

A BGP message with a type value 7 is used by the network device to send the local compression parameter to the control device. For example, the network device in the embodiment shown in FIG. 3 may send the local compression parameter to the control device by sending the BGP message with the type value 7 to the control device.

A BGP message with a type value 8 is used by the control device to send the global compression parameter to the network device. For example, the control device in the embodiment shown in FIG. 3 may send the global compression parameter to the network device by sending the BGP message with the type value 8 to the network device.

ABGP message with a type value 9 is used by the control device to send a compression policy to the network device. The compression policy includes a synchronization policy and/or a retention policy, the synchronization policy is used by the network device to generate and send the local compression parameter, and the retention policy indicates the network device to store at least one global compression parameter before the first global compression parameter. The following describes the compression policy in detail, and details are not described herein again.

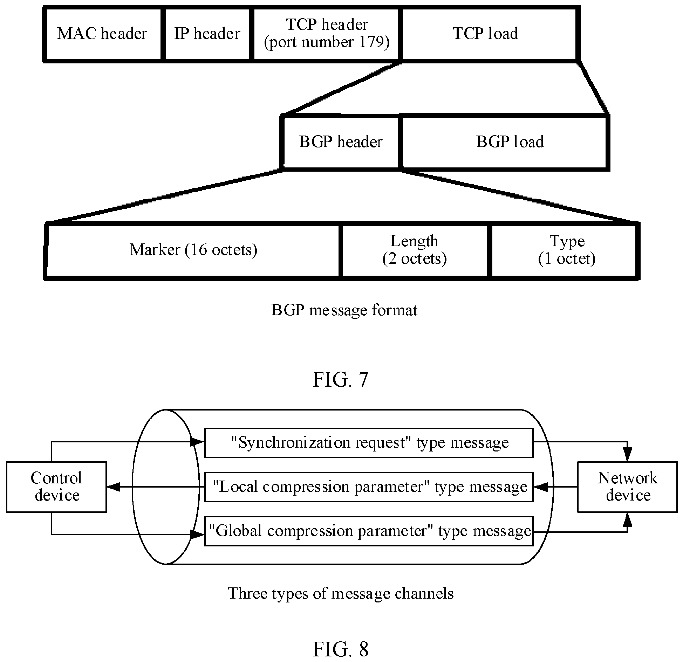

For example, a BGP extension packet is described by using an example in which the BGP message is transmitted based on a transmission control protocol (Transmission Control Protocol, TCP). As shown in FIG. 7, a TCP packet includes a MAC header, an IP header, a TCP header, and a TCP load. The TCP load includes a BGP header and a BGP load. A last byte of the BGP header is "type". For a value of the type, refer to the foregoing description of the type values 1 to 9. In addition, a BGP load corresponding to the BGP message with the type value 7 may be a local compression parameter, a BGP load corresponding to the BGP message with the type value 8 may be a global compression parameter, and a BGP load corresponding to the BGP message with the type value 9 may be a compression policy.

In a second manner, the control device communicates with the network device by using a publish-subscribe mechanism.

In this case, the control device communicates with the network device by using the publish-subscribe mechanism. A message publisher provides an interface for the outside. A message subscriber subscribes to a message channel through the interface. The message publisher publishes a message on the message channel, and the message subscriber obtains the message from the message channel. For example, the control device and the network device may share information through message middleware. For example, the message middleware is kafka or ActiveMQ.

This case may also be understood as follows: The network device subscribes to a message channel published by the control device, and the control device subscribes to a channel published by at least one network device. The at least one network device may include one or more of the following network devices: the second network device or the third network device.

For example, as shown in FIG. 8, three message channels are used as an example, and each message channel carries one type of message. The three types of messages include a "synchronization request" type message, a "local compression parameter" type message, and a "global compression parameter" type message. The "synchronization request" type message is used by a control device to send a synchronization request to a network device, where the synchronization request is used to obtain a local compression parameter. For example, the control device in the embodiment shown in FIG. 3 may send a synchronization request to the network device by using a "synchronization request" type message. The "local compression parameter" type message is used by the network device to send a local compression parameter to the control device. For example, the network device in the embodiment shown in FIG. 3 may report a local compression parameter to the control device by using a "local compression parameter" type message. The "global compression parameter" type message is used by the control device to send a global compression parameter to the network device. For example, the control device in the embodiment shown in FIG. 3 may deliver a global compression parameter to the at least one network device by using the "global compression parameter" type message. It may be understood that a "compression policy" type message (not shown in FIG. 8) may also be added, and the "compression policy" type message is used by the control device to deliver a compression policy to the network device.

It may be understood that the foregoing two manners are merely examples. In actual application, the control device and the network device may alternatively interact in another manner, for example, interact by using a customized protocol. This is not specifically limited herein.

Optionally, in the embodiment shown in FIG. 3, before the network device sends the local compression parameter to the control device, the network device may further receive the synchronization request sent by the control device, where the synchronization request is used to collect the local compression parameter of the network device, or it is understood that the synchronization request is used by the control device to actively obtain the local compression parameter of the network device. The control device may send the synchronization request to the network device in the network scenario shown in FIG. 1 in a broadcast manner, a multicast, a unicast manner, or the like.

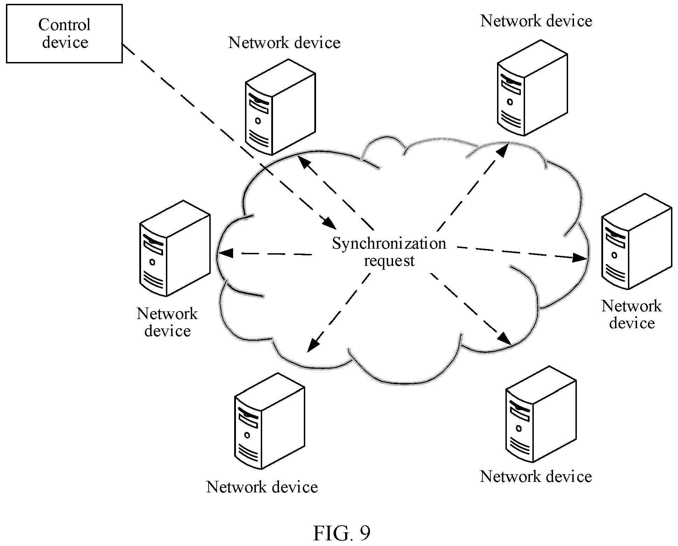

For example, FIG. 9 shows an example in which a control device sends a synchronization request to the network devices in the network scenario shown in FIG. 1.

It should be noted that the control device may store local compression parameters (a specific quantity may be set based on an actual requirement) reported by the network devices. When receiving no new local compression parameter reported by a network device, the control device may update a global compression parameter based on a stored local compression parameter of the network device and the new local compression parameters reported by the other network devices.

Optionally, the control device may further set different compression policies for different service types, for example, generate different global compression parameters. Packets of the different service types may have different characteristics, and therefore the packets of the different service types may have different compression ratios. After distinguishing the service types, the control device may generate a global compression parameter for a service type with a high compression ratio, and does not generate a global compression parameter for a service type with a low compression ratio, that is, the network device does not compress a packet of a service type with a low compression ratio. In addition, the different service types have different service requirements. For example, a speech-type service requires a low latency, and a download-type service requires a high throughput. The control device may generate different global compression parameters based on the service requirements of various service types. For example, for a low-latency service, the control device generates a short dictionary, to reduce a latency of querying the dictionary by the network device for encoding. For another example, for a high-throughput service, the control device generates a long dictionary, so that the network device can compress to-be-transmitted data as much as possible. For another example, for a high-throughput service, the control device may further set a compression policy for a plurality of times, so that the network device compresses data of the high-throughput service for a plurality of times to reduce an amount of to-be-transmitted data as much as possible. For example, dictionary compression is first performed, and then entropy encoding compression is performed.

For example, service types of data in embodiments of this application may specifically include the following types.

Type 1 is a low-latency service, for example, an instant messaging service. This type of service has a high requirement on an end-to-end transmission latency. For this type of service, to meet the low-latency requirement, it is not recommended that the network device spends long time in compression processing. Therefore, when the control device generates a global compression parameter for the low-latency service, a length of the compression parameter may be reduced, so that the network device can quickly complete compression on a packet.

Type 2 is a high-throughput service, for example, file download and database backup. This type of service has a large amount of data and has a high requirement for a network bandwidth but a low-latency requirement. To reduce network resource consumption of this type of service, when generating a global compression parameter for the high-throughput service, the control device may increase a length of the compression parameter, so that the network device can compress to-be-transmitted data as much as possible, improve a compression ratio of the to-be-transmitted data, and reduce network resource consumption of this type of service. The control device may further set compression for this type of service for a plurality of times, to further reduce a data amount of the to-be-transmitted data.

Type 3 is a service that does not need to be compressed, for example, an image and a video. Data of this type of service is already fully compressed, and space for the network device to compress the data again is not large. Therefore, the network device may not need to compress this type of service, and the control device does not need to generate/update a global compression parameter for this type of service.

Type 4 is another service. The another service may be a compressible service that has no requirement for a latency or a throughput. For the another service, a length of a global compression parameter generated by the control device may be between a length of a global compression parameter for a low-latency service and a length of a global compression parameter for a high-throughput service.

In addition, the device (for example, the network device or the control device) may determine, based on at least one of a 5-tuple, a flow identifier, a packet interval, a specific packet field, and the like of a data packet, a service type to which the data packet belongs, or may clarify, in a manner such as receiving a configuration policy, a service type to which the data packet belongs. This is not specifically limited herein. The configuration policy may include a service type and a corresponding compression policy. The compression policy includes whether compression is enabled, and whether compression is performed for a plurality of times.

Optionally, that the network device obtains a compression parameter (which may be referred to as a service local compression parameter) of a specific service may specifically include that the network device generates the service local compression parameter of a specific service type by using a training packet of the specific service type, and reports the service local compression parameter to the control device. To enable the control device to quickly distinguish a service type to which each service local compression parameter belongs, the network device may further report a service identifier to which each service local compression parameter belongs, where the service identifier indicates the service type to which the local compression parameter belongs. Therefore, in a process of generating a global compression parameter of the specific service, the control device may select the local compression parameters based on the service identifier.

Further, to adapt the subsequent global compression parameter to the specific service, the service type of the training packet used by the network device in a process of generating the local compression parameter is consistent with a service type of a packet that subsequently compressed/decompressed by the network device.

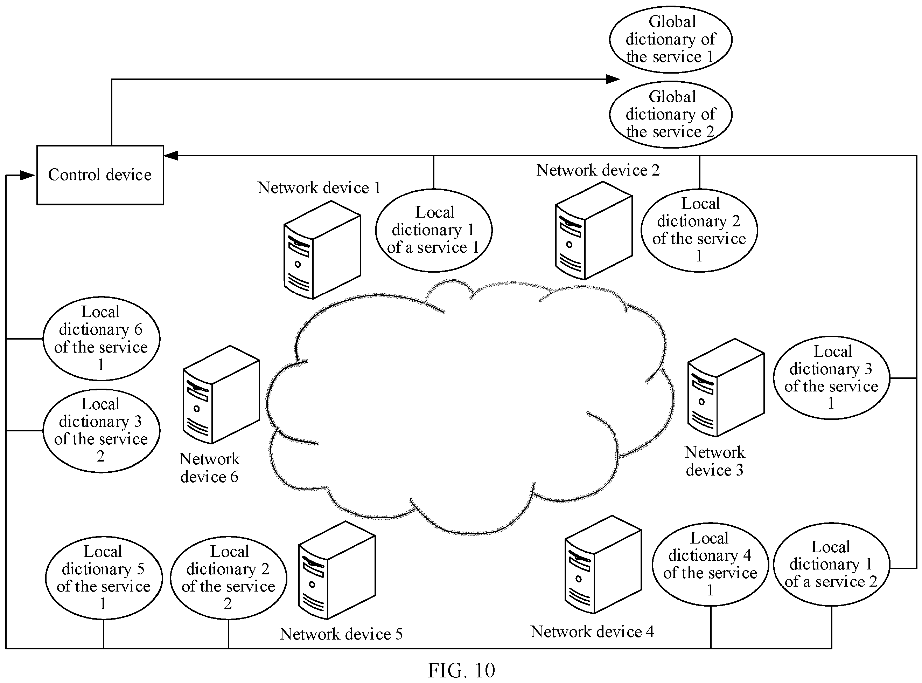

For example, a compression parameter is a dictionary. FIG. 10 shows an example in which different network devices generate different service local dictionaries. A network device 1 generates a local dictionary 1 of a service 1 by using a training packet of the service 1. A network device 2 generates a local dictionary 2 of the service 1 by using the training packet of the service 1. A network device 3 generates a local dictionary 3 of the service 1 by using the training packet of the service 1. A network device 4 generates a local dictionary 4 of the service 1 by using the training packet of the service 1, and generates a local dictionary 1 of a service 2 by using a training packet of the service 2. A network device 5 generates a local dictionary 5 of the service 1 by using the training packet of the service 1, and generates a local dictionary 2 of the service 2 by using the training packet of the service 2. A network device 6 generates a local dictionary 6 of the service 1 by using the training packet of the service 1, and generates a local dictionary 3 of the service 2 by using the training packet of the service 2. The network device 1 to the network device 6 send the service local dictionaries and corresponding service identifiers to a control device. After receiving the service local dictionaries reported by the network devices, the control device generates corresponding global dictionaries based on local dictionaries of a same service identifier. Specifically, the control device generates a global dictionary of the service 1 based on the local dictionary 1 of the service 1, the local dictionary 2 of the service 1, the local dictionary 3 of the service 1, the local dictionary 4 of the service 1, the local dictionary 5 of the service 1, and the local dictionary 6 of the service 1. The control device generates a global dictionary of the service 2 based on the local dictionary 1 of the service 2, the local dictionary 2 of the service 2, and the local dictionary 3 of the service 2.

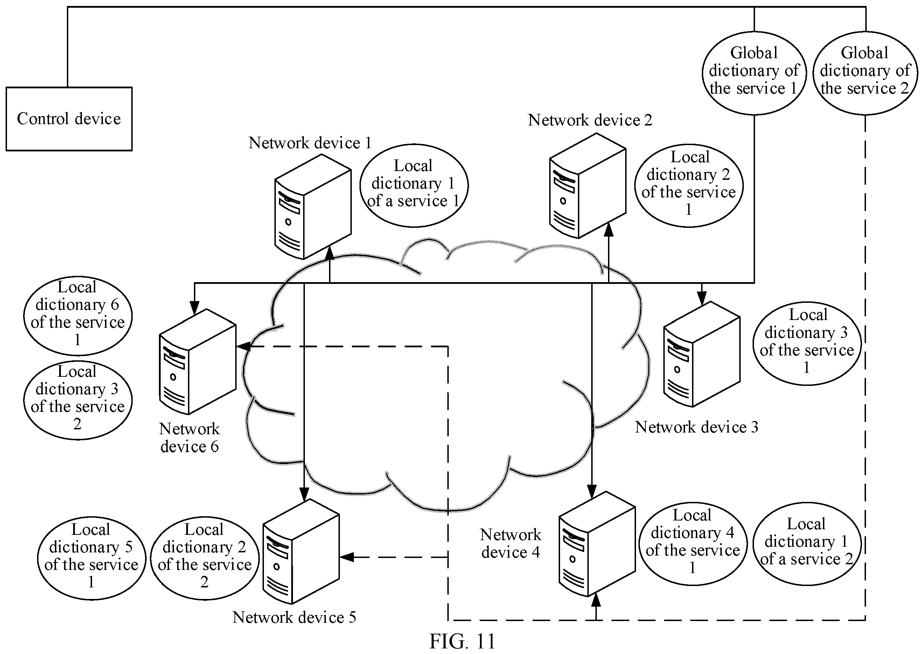

For example, the foregoing example in FIG. 10 is continued. FIG. 11 shows an example of delivering service global dictionaries by the control device. Generally, specific service global dictionaries sent to the network devices are determined based on service types of the local dictionaries reported by the network devices. Specifically, the control device sends the global dictionary of the service 1 to the network device 1 to the network device 6. The control device sends the global dictionary of the service 2 to the network device 4 to the network device 6. This enables that the network devices process data packets of different services by using the received service global dictionaries.

In addition, the network management device/control device may further control, according to a first compression policy, the network device to perform a process of synchronizing the compression parameter. Before the network device obtains the local compression parameter, the network device may further obtain the first compression policy from the network management device/control device. The first compression policy includes a synchronization policy and/or a retention policy, the synchronization policy is used by the network device to generate and send the local compression parameter, and the retention policy indicates the network device to store at least one global compression parameter before the first global compression parameter. The retention policy may also be understood as being used to indicate a quantity of global compression parameters stored by the network device.

Further, the synchronization policy in the first compression policy may include at least one of a service type and a corresponding compression policy, a moment or a periodicity at which the network device generates/sends the local compression parameter, a first preset condition, and the like. The service type indicates the network device to separately generate a local compression parameter for the service type or not to generate a local compression parameter for the service type. For example, if a compression policy of a service type is enabling compression, the network device is indicated to generate a local compression parameter of the service type by using a packet of the service type; or if a compression policy of a service type is disabling compression, the network device is indicated not to compress a packet of the service type, and not to generate a local compression parameter by using the packet of the service type. The service type may be represented by using a 5-tuple, a flow identifier, a packet feature, or a packet specific field. The packet feature is, for example, a packet interval, or a packet size. The retention policy in the first compression policy includes a quantity of global compression parameters stored by the network device, and the like. It may be understood that, if the network device initially configures no compression parameter, the first compression policy may further include an initial compression parameter.

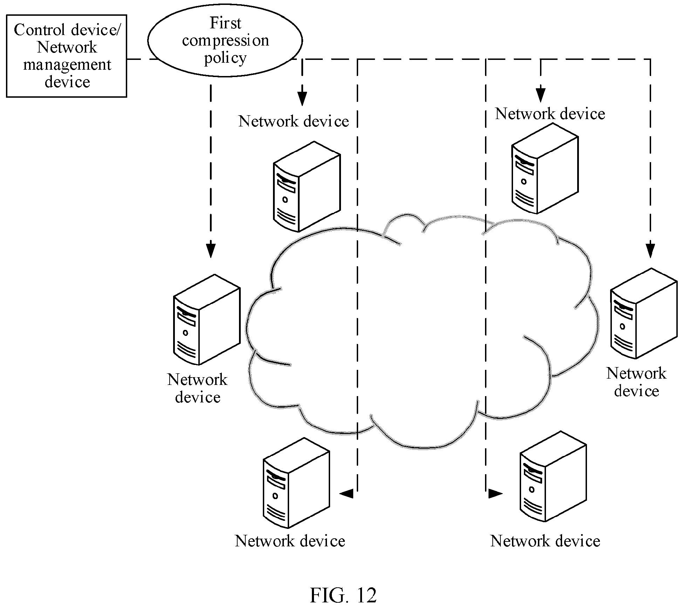

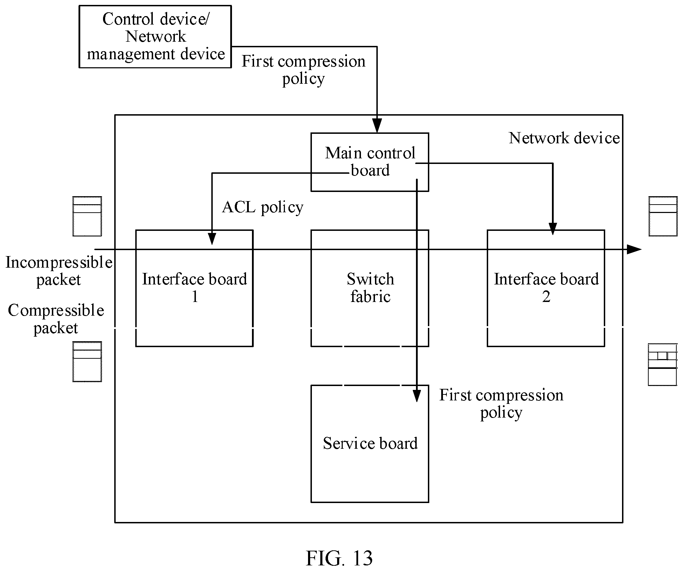

For example, the network scenario in FIG. 1 is used as an example, a process of delivering the first compression policy may be shown in FIG. 12. The control device/network management device delivers the first compression policy to each network device. Further, in addition to those in the foregoing description, the first compression policy may further include one or more of the following: whether enabling a compression parameter, a compression manner (for example, dictionary compression, coding table compression, or secondary compression), whether configuring a compression parameter based on a service (that is, whether the foregoing mentioned local compression parameter is related to the service type), an election rule of a first network device, and a communication rule of a network device. With reference to the network device shown in FIG. 3, an application process of the first compression policy is described. As shown in FIG. 13, the control device/network management device sends the first compression policy to the network device. After receiving the first compression policy, the main control board of the network device delivers the first compression policy to the service boards, so that the service boards generate/send local compression parameters according to the first compression policy. In addition, the main control board may further obtain an access control list (Access Control List, ACL) policy, and send the ACL policy to the interface board, where the ACL policy may indicate the interface board to forward, to the service board, a packet on which compression processing needs to be performed. The interface board sends and receives a packet according to the ACL policy. Specifically, the interface board forwards a compressible packet (a packet that matches the ACL policy) to the service board, and forwards an incompressible packet to another interface board. The ACL policy may be generated by the control device and sent to the network device, or may be generated by the main control board of the network device according to the first compression policy. For example, if the first compression policy specifies a 5-tuple of a data flow on which compression processing needs to be performed, the ACL policy indicates the interface board to forward, to the service board, a packet corresponding to the 5-tuple.

In the foregoing manner, in one aspect, the network management device or the control device may control, according to the first compression policy, the network device to generate and send the local compression parameter. In another aspect, because the incompressible packet does not need to enter the service board, blocking of a to-be-processed packet in the service board can be reduced, and performance of the network device is improved.

Similarly, the control device may further obtain a second compression policy. For example, the control device receives the second compression policy from a network management device, or receives the second compression policy configured by a user. The second compression policy includes one or more of the following: a moment or a periodicity at which the control device generates/sends the first global compression parameter, a moment or a periodicity at which the control device sends the synchronization request, a service type and a corresponding compression policy, and a second preset condition.

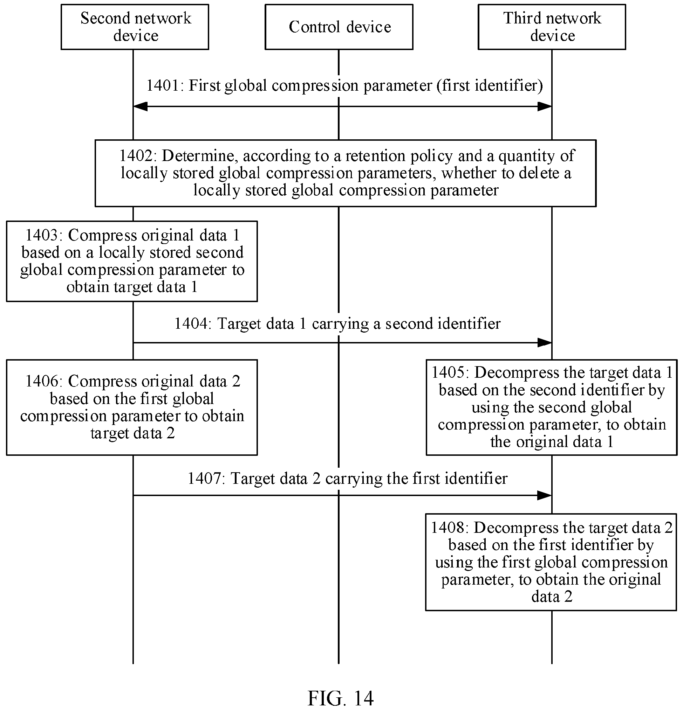

In addition, to facilitate the network device to locally store a plurality of global compression parameters (as described in the foregoing retention policy), in addition to sending the global compression parameter to the network device, the control device further sends an identifier of the global compression parameter. With reference to FIG. 14, the following describes, by using an example in which a control device sends a global compression parameter to a second network device and a third network device, a method for using an identifier in a processing procedure. The method includes step 1401 to step 1408, which are separately described below.

Step 1401: The control device sends, to the second network device and the third network device, the first global compression parameter carrying the first identifier. Correspondingly, the second network device and the third network device receive the first global compression parameter that carries the first identifier and that is sent by the control device.

Optionally, before this step, the control device may generate the first global compression parameter based on a first local compression parameter and a second local compression parameter, where the first local compression parameter is generated by the second network device, and the second local compression parameter is generated by the third network device.

After generating the first global compression parameter, the control device may send, to the second network device and the third network device, the first global compression parameter carrying the first identifier. The first identifier identifies the first global compression parameter. For example, the first identifier is a version number of the first global compression parameter.

Optionally, when the compression parameter is related to a service type, the first identifier may further indicate a service type to which the first global compression parameter belongs. For example, first several bits of the first identifier indicate the version number, and last several bits indicate the service type.

Step 1402: The second network device and the third network device determine, according to a retention policy and a quantity of locally stored global compression parameters, whether to delete a locally stored global compression parameter.

Optionally, the network devices (namely, the second network device and the third network device) obtain the retention policy before this step, and the retention policy indicates a quantity of global compression parameters stored by the network devices.

After receiving the global compression parameter, the network devices find that the quantity of locally stored global compression parameters may exceed the quantity in the retention policy, and delete a locally stored global compression parameter with a smallest identifier (it is assumed that the identifier of the new global compression parameter is greater than identifiers of the old global compression parameters).

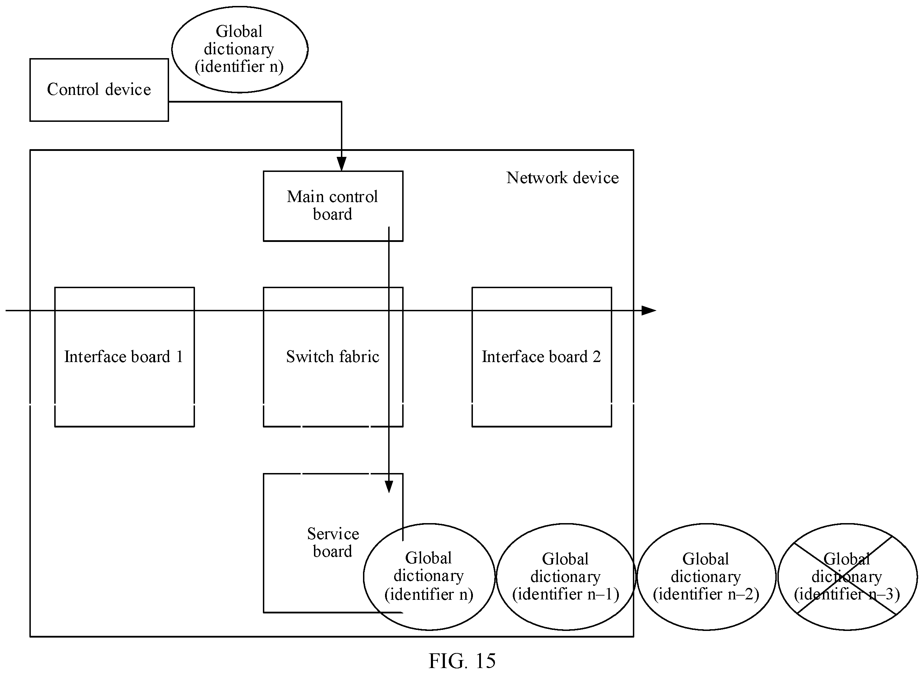

For example, it is assumed that the retention policy indicates that the quantity of global compression parameters stored in the network devices is 3, and the network devices already store three versions of global compression parameters before receiving the first global compression parameter, after receiving the first global compression parameter, the network devices may remove an earliest version from the locally stored three versions of global compression parameters, so as to ensure that the retention policy is met. Further, with reference to the hardware architecture shown in FIG. 3, an example in which the global compression parameter is a global compression dictionary is used, and a process of deleting an earliest version of a global dictionary is shown in FIG. 15. The control device sends the first global compression parameter (identifier n) to the network device. After receiving the first global compression parameter, the main control board of the network device sends the first global compression parameter (identifier n) to the service board. Before receiving the first global compression parameter (identifier n), the service board already stores three versions of global compression parameters (identifier n-1, identifier n-2, and identifier n-3). After receiving the first global compression parameter (identifier n), the service board may delete the earliest version (namely, the global dictionary with the identifier n-3) of the three versions of global compression parameters stored locally.

Further, after receiving the global compression parameter with the first identifier, the network devices may first check identifiers of the locally stored global compression parameters. If the identifiers of the locally stored global compression parameters are less than the first identifier, the network devices use the first global compression parameter to perform at least one of the following: updating the locally stored global compression parameters, updating the local compression parameters, or directly replacing the locally stored global compression parameter with the first global compression parameter.

For example, the example in FIG. 15 is continued, if the service board already has a global dictionary with an identifier n, the service board uses the global dictionary with the identifier n to compress a data packet, and continuously generates and updates the local dictionary in a compression process. Specifically, after receiving the global dictionary, the service board may further update a local dictionary based on the global dictionary. For example, at a moment T, the service board receives the global dictionary with the identifier n, including content of a string 1, a string 2, and a string 3. When the service board compresses the data packet by using the global dictionary with the identifier n, the string 1 does not occur, and a new string is denoted as a string 4. Therefore, the service board performs dictionary training to obtain a local dictionary with an identifier n-1, including content of the string 2, and the string 4.

Step 1403: The second network device compresses original data 1 based on a locally stored second global compression parameter to obtain target data 1.

The second network device compresses the original data 1 based on the locally stored second global compression parameter to obtain the target data 1.

Step 1404: The second network device sends, to the third network device, the target data 1 carrying a second identifier. Correspondingly, the third network device receives the target data 1 that carries the second identifier and that is sent by the second network device.

After compressing the original data 1 based on the locally stored second global compression parameter to obtain the target data 1, the second network device may send, to the third network device, the target data 1 carrying the second identifier. The second identifier indicates a second global compression parameter.

Step 1405: The third network device decompresses the target data 1 based on the second identifier by using the second global compression parameter, to obtain the original data 1.

After receiving the target data 1 that carries the second identifier and that is sent by the second network device, the third network device determines, based on the second identifier, the second global compression parameter for decompressing the target data 1, and decompresses the target data 1 by using the second global compression parameter, to obtain the original data 1.

Step 1406: The second network device compresses original data 2 based on the locally stored first global compression parameter to obtain target data 2.

The second network device compresses the original data 2 based on the first global compression parameter to obtain the target data 2.

Step 1407: The second network device sends, to the third network device, the target data 2 carrying the first identifier. Correspondingly, the third network device receives the target data 2 that carries the first identifier and that is sent by the second network device.

After compressing the original data 2 based on the first global compression parameter to obtain the target data 2, the second network device may send, to the third network device, the target data 2 carrying the first identifier. The first identifier indicates the first global compression parameter.

Step 1408: The third network device decompresses the target data 2 based on the first identifier by using the first global compression parameter, to obtain the original data 2.

After receiving the target data 2 that carries the first identifier and that is sent by the second network device, the third network device determines, based on the first identifier, the first global compression parameter for decompressing the target data 2, and decompresses the target data 2 by using the first global compression parameter, to obtain the original data 2.

In this embodiment, a time sequence between steps is not limited. For example, step 1403 may be performed before step 1401, step 1404 may be performed after step 1401, and step 1406 may be performed before step 1403.

In this embodiment, a data sender can flexibly select a compression parameter, and a data receiver can select, based on an identifier of a compression parameter carried in a received packet, correct compression parameter for decompression. This enhances flexibility of the solution. In addition, when the data receiver does not store the compression parameter selected by the data sender, the data receiver can further carry the identifier of the compression parameter carried in the received packet to obtain the compression parameter from the control device for decompression. This enhances robustness of the solution.

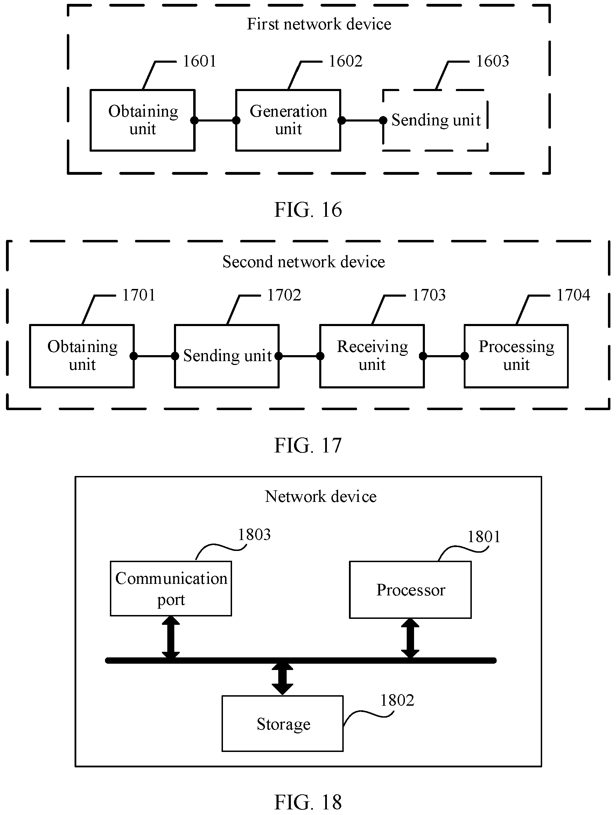

The foregoing describes the data processing method provided in embodiments of this application. The following describes the first network device provided in embodiments of this application. Refer to FIG. 16. An embodiment of a first network device in this application includes an obtaining unit 1601 and a generation unit 1602.

The obtaining unit 1601 is configured to obtain a first local compression parameter and a second local compression parameter. The first local compression parameter is generated by the first network device or a second network device, and the second local compression parameter is generated by a third network device.

The generation unit 1602 is configured to generate a first global compression parameter based on the first local compression parameter and the second local compression parameter. The first global compression parameter is for compression and decompression.

Optionally, the first network device in this embodiment further includes a sending unit 1603. The sending unit 1603 is configured to send the first global compression parameter to at least one network device, where the at least one network device includes one or more of the following network devices: the second network device or the third network device.

Optionally, the sending unit 1603 is further configured to send a synchronization request to the second network device and/or the third network device to request the first local compression parameter and/or the second local compression parameter.

Optionally, the sending unit 1603 is further configured to send a first compression policy to the second network device and/or the third network device.

In this embodiment, operations performed by the units in the first network device are similar to those described in embodiments shown in FIG. 4 to FIG. 15. Details are not described herein again.

In this embodiment, the network device only needs to synchronize the compression parameter with the first network device. This reduces complexity of maintaining the compression parameter. In addition, the generation unit 1602 updates the global compression parameter based on local compression parameters generated by a plurality of other network devices, so that the global compression parameter is obtained based on a data processing result in a wider range. This further improves data compression efficiency.

Refer to FIG. 17, an embodiment of a second network device in this application includes an obtaining unit 1701, a sending unit 1702, a receiving unit 1703, and a processing unit 1704.

The obtaining unit 1701 is configured to obtain a first local compression parameter.

The sending unit 1702 is configured to send the first local compression parameter to a first network device.

The receiving unit 1703 is configured to receive a first global compression parameter sent by the first network device, where the first global compression parameter is generated based on the first local compression parameter and a second local compression parameter.

The processing unit 1704 is configured to compress/decompress target data based on the first global compression parameter, where the target data is data transmitted by the second network device.

In this embodiment, operations performed by the units in the second network device are similar to those described in embodiments shown in FIG. 4 to FIG. 15. Details are not described herein again.

In this embodiment, the sending unit 1702 sends the first local compression parameter to the first network device, so that the first network device can generate the first global compression parameter based on the first local compression parameter. The receiving unit 1703 receives the first global compression parameter sent by the first network device, where the first global compression parameter is used by the processing unit 1704 to compress/decompress the target data transmitted by the second network device. The network device only needs to synchronize the compression parameter with the first network device, and the network device only needs to maintain a few global compression parameters (for example, one global compression parameter) from the first network device, and does not need to maintain one global compression parameter for each other network device, thereby reducing complexity of maintaining the compression parameter. In addition, the first global compression parameter is obtained by the first network device by updating local compression parameters generated by a plurality of other network devices, so that the first global compression parameter is obtained based on a data processing result in a wider range. This further improves data compression efficiency.

FIG. 18 is a diagram of a structure of a network device according to an embodiment of this application. The network device may be the first network device or the second network device in the embodiment shown in FIG. 4. The network device may include a processor 1801, a storage 1802, and a communication port 1803. The processor 1801, the storage 1802, and the communication port 1803 are interconnected through a line. The storage 1802 stores program instructions and data.

The storage 1802 stores program instructions and data that correspond to the steps performed by the first network device/second network device in implementations corresponding to FIG. 4 to FIG. 15.

The processor 1801 is configured to perform the steps that are performed by the first network device/second network device and that are shown in any one of embodiments shown in FIG. 4 to FIG. 15.

The communication port 1803 may be configured to receive and send data, and is configured to perform steps related to obtaining, sending, and receiving in any one of embodiments shown in FIG. 4 to FIG. 15.

In an implementation, the network device may include more or fewer components than those in FIG. 18. This application is merely an example for description, and is not limited.

It may be clearly understood by a person skilled in the art that, for the purpose of convenient and brief description, for a detailed working process of the foregoing system, apparatus, and unit, refer to a corresponding process in the foregoing method embodiments, and details are not described herein again.

In the several embodiments provided in this application, it should be understood that the disclosed system, apparatus, and method may be implemented in other manners. For example, the described apparatus embodiments are merely examples. For example, division into the units is merely logical function division and may be other division in actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electronic, mechanical, or other forms.

The units described as separate parts may or may not be physically separate, and parts displayed as units may or may not be physical units, may be located in one location, or may be distributed on a plurality of network units. Some or all of the units may be selected based on actual requirements to achieve the objectives of the solutions of embodiments.

In addition, functional units in embodiments of this application may be integrated into one processing unit, each of the units may exist alone physically, or two or more units are integrated into one unit. The integrated unit may be implemented in a form of hardware, or may be implemented in a form of a software functional unit.

When the integrated unit is implemented in the form of the software functional unit and sold or used as an independent product, the integrated unit may be stored in a computer-readable storage medium. Based on such an understanding, the technical solutions of this application essentially, or the part contributing to the conventional technology, or all or some of the technical solutions may be implemented in the form of a software product. The computer software product is stored in a storage medium and includes several instructions for instructing a computer device (which may be a personal computer, a server, or a network device) to perform all or some of the steps of the methods described in embodiments of this application. The foregoing storage medium includes any medium that can store program code, such as a USB flash drive, a removable hard disk, a read-only memory (ROM, read-only memory), a random access memory (RAM, random access memory), a magnetic disk, or an optical disc.

## Claims

1. A data processing method, wherein the method comprises:
obtaining, by a first network device, a first local compression parameter and a second local compression parameter, wherein the first local compression parameter is generated by the first network device or a second network device, and the second local compression parameter is generated by a third network device; and
generating, by the first network device, a first global compression parameter based on the first local compression parameter and the second local compression parameter, wherein the first global compression parameter is for compression and decompression,
wherein the method further comprises:
sending, by the first network device, the first global compression parameter to at least one network device, wherein the at least one network device comprises one or more of the following network devices: the second network device or the third network device; and
wherein the method further comprises:
communicating, by the first network device, with the second network device and/or the third network device based on a border gateway routing, BGP, message, wherein communication information comprises one or more of the following: a synchronization request, the first local compression parameter, the second local compression parameter, the first global compression parameter, or a first compression policy.

2. The method according to claim 1, wherein the method further comprises:
sending, by the first network device, the synchronization request to the second network device and/or the third network device, to request the first local compression parameter and/or the second local compression parameter.

3. The method according to claim 1 or 2, wherein the method further comprises:
sending, by the first network device, the first compression policy to the second network device and/or the third network device, wherein the first compression policy comprises a synchronization policy and/or a retention policy, the synchronization policy is used by the second network device and/or the third network device to generate and send a local compression parameter, and the retention policy indicates the second network device and/or the third network device to store at least one global compression parameter before the first global compression parameter.

4. The method according to claim 3, wherein the synchronization policy comprises a service type and a compression policy corresponding to the service type, and the service type and the compression policy corresponding to the service type indicate the second network device and/or the third network device to process, based on the service type and the compression policy corresponding to the service type, a packet corresponding to the service type, and/or generate, based on the service type and the compression policy corresponding to the service type, a local compression parameter corresponding to the service type.

5. The method according to any one of claims 1 to 4, wherein the method further comprises:
sending, by the first network device, a first identifier to the at least one network device, wherein the first identifier identifies the first global compression parameter.

6. The method according to any one of claims 1 to 5, wherein the method further comprises:
obtaining, by the first network device, a second compression policy, wherein the second compression policy comprises one or more of the following: a moment or a periodicity at which the first network device generates/sends the first global compression parameter, a moment or a periodicity at which the first network device sends the synchronization request, the service type and the compression policy corresponding to the service type, and a preset condition, wherein
the preset condition indicates the first network device to send the first global compression parameter when the preset condition is met.

7. The method according to any one of claims 1 to 6, wherein
the first local compression parameter, the second local compression parameter, and the first global compression parameter are dictionaries; and
the first local compression parameter comprises a first string, the second compression parameter comprises a second string, and the first global compression parameter comprises a union set of the first string and the second string.

8. The method according to any one of claims 1 to 6, wherein
the first local compression parameter is a first local coding table, the second local compression parameter is a second local coding table, and the first global compression parameter is a first global coding table;
the first local coding table comprises a frequency or a quantity of times of a first element, the second local coding table comprises a frequency or a quantity of times of a second element, and the first element and the second element are elements in a coding character set; and
the generating, by the first network device, a first global compression parameter based on the first local compression parameter and the second local compression parameter comprises:
generating, by the first network device, the first global coding table based on the frequency or the quantity of times of the first element and the frequency or the quantity of times of the second element, wherein the first global coding table comprises elements in the coding character set and codeword corresponding to the elements.

9. The method according to any one of claims 6 to 8, wherein the preset condition comprises at least one of the following:
time of the first network device is a preset moment, or a time interval from a moment at which a global compression parameter is sent to the at least one network device last time reaches or exceeds a preset time period;
a variation amount of a quantity of occurrence times or an occurrence frequency of at least one element in the first global compression parameter is greater than or equal to a first threshold;
a difference between a length of a string in the first global compression parameter and a length of a string in the second global compression parameter is greater than or equal to a second threshold;
a ratio of a length of a string in the first global compression parameter to a length of a string in the second global compression parameter is greater than or equal to a third threshold; and
in a process of generating the first global compression parameter based on the second global compression parameter, a quantity of times of adjusting a sequence of substrings or elements in the second global compression parameter is greater than or equal to a fourth threshold.

10. A data processing method, wherein the method comprises:
obtaining, by a second network device, a first local compression parameter;
sending, by the second network device, the first local compression parameter to a first network device;
receiving, by the second network device, a first global compression parameter sent by the first network device, wherein the first global compression parameter is generated based on the first local compression parameter and a second local compression parameter; and
compressing/decompressing, by the second network device, target data based on the first global compression parameter, wherein the target data is data transmitted by the second network device,
wherein the second network device communicates with the first network device based on a border gateway routing, BGP, message, and communication information comprises one or more of the following: a synchronization request, the first local compression parameter, the first global compression parameter, or a compression policy.

11. The method according to claim 10, wherein the sending, by the second network device, the first local compression parameter to a first network device comprises:
if a preset condition is met, sending, by the second network device, the first local compression parameter to the first network device, wherein
the preset condition comprises at least one of the following:
a compression ratio of a second global compression parameter stored in the second network device is less than or equal to a first threshold;
a quantity of packets or a byte length of a packet processed by the second network device is greater than or equal to a second threshold; and
time of the second network device is a preset moment, or a time interval from a moment at which a local compression parameter is sent to the first network device last time reaches or exceeds a preset time period; and
receiving, by the second network device, a synchronization request sent by the first network device, wherein the synchronization request is used to collect the first local compression parameter.

12. The method according to claim 10 or claim 11, wherein the method further comprises: obtaining, by the second network device, the compression policy, wherein the compression policy comprises a synchronization policy and/or a retention policy, the synchronization policy is used by the second network device to generate and send a local compression parameter, and the retention policy indicates the second network device to store at least one global compression parameter before the first global compression parameter.

13. A network device, wherein the network device is configured to implement the method according to any one of claims 1 to 12.

## Patentansprüche

1. Datenverarbeitungsverfahren, wobei das Verfahren Folgendes umfasst:
Erhalten, durch eine erste Netzwerkvorrichtung, eines ersten lokalen Komprimierungsparameters und eines zweiten lokalen Komprimierungsparameters, wobei der erste lokale Komprimierungsparameter durch die erste Netzwerkvorrichtung oder eine zweite Netzwerkvorrichtung generiert wird und der zweite lokale Komprimierungsparameter durch eine dritte Netzwerkvorrichtung generiert wird; und
Generieren, durch die erste Netzwerkvorrichtung, eines ersten globalen Komprimierungsparameters basierend auf dem ersten lokalen Komprimierungsparameter und dem zweiten lokalen Komprimierungsparameter, wobei der erste globale Komprimierungsparameter zur Komprimierung und Dekomprimierung dient,
wobei das Verfahren ferner Folgendes umfasst:
Senden, durch die erste Netzwerkvorrichtung, des ersten globalen Komprimierungsparameters an mindestens eine Netzwerkvorrichtung, wobei die mindestens eine Netzwerkvorrichtung eine oder mehrere der folgenden Netzwerkvorrichtungen umfasst: die zweite Netzwerkvorrichtung oder die dritte Netzwerkvorrichtung; und
wobei das Verfahren ferner Folgendes umfasst:
Kommunizieren, durch die erste Netzwerkvorrichtung, mit der zweiten Netzwerkvorrichtung und/oder der dritten Netzwerkvorrichtung basierend auf einer Border-Gateway-Routing-Nachricht, BGP, wobei Kommunikationsinformationen eines oder mehrere von dem Folgenden umfassen: eine Synchronisierungsanforderung, den ersten lokalen Komprimierungsparameter, den zweiten lokalen Komprimierungsparameter, den ersten globalen Komprimierungsparameter oder eine erste Komprimierungsrichtlinie.

2. Verfahren nach Anspruch 1, wobei das Verfahren ferner Folgendes umfasst:
Senden, durch die erste Netzwerkvorrichtung, der Synchronisierungsanforderung an die zweite Netzwerkvorrichtung und/oder die dritte Netzwerkvorrichtung, um den ersten lokalen Komprimierungsparameter und/oder den zweiten lokalen Komprimierungsparameter anzufordern.

3. Verfahren nach Anspruch 1 oder 2, wobei das Verfahren ferner Folgendes umfasst:
Senden, durch die erste Netzwerkvorrichtung, der ersten Komprimierungsrichtlinie an die zweite Netzwerkvorrichtung und/oder die dritte Netzwerkvorrichtung, wobei die erste Komprimierungsrichtlinie eine Synchronisierungsrichtlinie und/oder eine Aufbewahrungsrichtlinie umfasst, die Synchronisierungsrichtlinie durch die zweite Netzwerkvorrichtung und/oder die dritte Netzwerkvorrichtung verwendet wird, um einen lokalen Komprimierungsparameter zu generieren und zu senden, und die Aufbewahrungsrichtlinie die zweite Netzwerkvorrichtung und/oder die dritte Netzwerkvorrichtung anweist, vor dem ersten globalen Komprimierungsparameter mindestens einen globalen Komprimierungsparameter zu speichern.

4. Verfahren nach Anspruch 3, wobei die Synchronisierungsrichtlinie einen Diensttyp und eine dem Diensttyp entsprechende Komprimierungsrichtlinie umfasst und der Diensttyp und die dem Diensttyp entsprechende Komprimierungsrichtlinie die zweite Netzwerkvorrichtung und/oder die dritte Netzwerkvorrichtung anweisen, basierend auf dem Diensttyp und der dem Diensttyp entsprechenden Komprimierungsrichtlinie ein dem Diensttyp entsprechendes Paket zu verarbeiten und/oder basierend auf dem Diensttyp und der dem Diensttyp entsprechenden Komprimierungsrichtlinie einen dem Diensttyp entsprechenden lokalen Komprimierungsparameter zu generieren.

5. Verfahren nach einem der Ansprüche 1 bis 4, wobei das Verfahren ferner Folgendes umfasst:
Senden, durch die erste Netzwerkvorrichtung, einer ersten Kennung an die mindestens eine Netzwerkvorrichtung, wobei die erste Kennung den ersten globalen Komprimierungsparameter identifiziert.

6. Verfahren nach einem der Ansprüche 1 bis 5, wobei das Verfahren ferner Folgendes umfasst:
Erhalten, durch die erste Netzwerkvorrichtung, einer zweiten Komprimierungsrichtlinie, wobei die zweite Komprimierungsrichtlinie eines oder mehrere von dem Folgenden umfasst: einen Zeitpunkt oder eine Periodizität, zu dem oder mit der die erste Netzwerkvorrichtung den ersten globalen Komprimierungsparameter generiert/sendet, einen Zeitpunkt oder eine Periodizität, zu dem oder mit der die erste Netzwerkvorrichtung die Synchronisierungsanforderung sendet, den Diensttyp und die dem Diensttyp entsprechende Komprimierungsrichtlinie und eine voreingestellte Bedingung, wobei
die voreingestellte Bedingung die erste Netzwerkvorrichtung anweist, den ersten globalen Komprimierungsparameter zu senden, wenn die voreingestellte Bedingung erfüllt ist.

7. Verfahren nach einem der Ansprüche 1 bis 6, wobei
der erste lokale Komprimierungsparameter, der zweite lokale Komprimierungsparameter und der erste globale Komprimierungsparameter Wörterbücher sind; und
der erste lokale Komprimierungsparameter einen ersten String umfasst, der zweite Komprimierungsparameter einen zweiten String umfasst und der erste globale Komprimierungsparameter eine Vereinigungsmenge des ersten Strings und des zweiten Strings umfasst.

8. Verfahren nach einem der Ansprüche 1 bis 6, wobei
der erste lokale Komprimierungsparameter eine erste lokale Codierungstabelle ist, der zweite lokale Komprimierungsparameter eine zweite lokale Codierungstabelle ist und der erste globale Komprimierungsparameter eine erste globale Codierungstabelle ist;
die erste lokale Codierungstabelle eine Häufigkeit oder eine Anzahl des Auftretens eines ersten Elements umfasst, die zweite lokale Codierungstabelle eine Häufigkeit oder eine Anzahl des Auftretens eines zweiten Elements umfasst und das erste Element und das zweite Element Elemente in einem Codierungszeichensatz sind; und
das Generieren, durch die erste Netzwerkvorrichtung, eines ersten globalen Komprimierungsparameters basierend auf dem ersten lokalen Komprimierungsparameter und dem zweiten lokalen Komprimierungsparameter Folgendes umfasst:
Generieren, durch die erste Netzwerkvorrichtung, der ersten globalen Codierungstabelle basierend auf der Häufigkeit oder der Anzahl des Auftretens des ersten Elements und der Häufigkeit oder der Anzahl des Auftretens des zweiten Elements, wobei die erste globale Codierungstabelle Elemente in dem Codierungszeichensatz und ein den Elementen entsprechendes Codewort umfasst.

9. Verfahren nach einem der Ansprüche 6 bis 8, wobei die voreingestellte Bedingung mindestens eines von dem Folgenden umfasst:
Die Zeit der ersten Netzwerkvorrichtung ist ein voreingestellter Zeitpunkt oder ein Zeitintervall erreicht oder überschreitet eine voreingestellte Zeitspanne ab einem Zeitpunkt, zu dem ein globaler Komprimierungsparameter zuletzt an die mindestens eine Netzwerkvorrichtung gesendet wird;
eine Variationsmenge einer Anzahl von Auftretensereignissen oder einer Auftretenshäufigkeit mindestens eines Elements in dem ersten globalen Komprimierungsparameter ist größer als ein erster oder gleich einem ersten Schwellenwert;
eine Differenz zwischen einer Länge eines Strings in dem ersten globalen Komprimierungsparameter und einer Länge eines Strings in dem zweiten globalen Komprimierungsparameter ist größer als ein zweiter oder gleich einem zweiten Schwellenwert;
ein Verhältnis einer Länge eines Strings in dem ersten globalen Komprimierungsparameter zu einer Länge eines Strings in dem zweiten globalen Komprimierungsparameter ist größer als ein dritter oder gleich einem dritten Schwellenwert; und
in einem Vorgang des Generierens des ersten globalen Komprimierungsparameters basierend auf dem zweiten globalen Komprimierungsparameter ist eine Anzahl des Auftretens eines Anpassens einer Sequenz von Teilstrings oder Elementen in dem zweiten globalen Komprimierungsparameter größer als ein vierter oder gleich einem vierten Schwellenwert.

10. Datenverarbeitungsverfahren, wobei das Verfahren Folgendes umfasst:
Erhalten, durch eine zweite Netzwerkvorrichtung, eines ersten lokalen Komprimierungsparameters;
Senden, durch die zweite Netzwerkvorrichtung, des ersten lokalen Komprimierungsparameters an eine erste Netzwerkvorrichtung;
Empfangen, durch die zweite Netzwerkvorrichtung, eines ersten globalen Komprimierungsparameters, der durch die erste Netzwerkvorrichtung gesendet wird, wobei der erste globale Komprimierungsparameter basierend auf dem ersten lokalen Komprimierungsparameter und einem zweiten lokalen Komprimierungsparameter generiert wird; und
Komprimieren/Dekomprimieren, durch die zweite Netzwerkvorrichtung, von Zieldaten basierend auf dem ersten globalen Komprimierungsparameter, wobei die Zieldaten Daten sind, die durch die zweite Netzwerkvorrichtung übertragen werden,
wobei die zweite Netzwerkvorrichtung mit der ersten Netzwerkvorrichtung basierend auf einer Border-Gateway-Routing-Nachricht, BGP, kommuniziert und Kommunikationsinformationen eines oder mehrere von dem Folgenden umfassen: eine Synchronisierungsanforderung, den ersten lokalen Komprimierungsparameter, den ersten globalen Komprimierungsparameter oder eine Komprimierungsrichtlinie.

11. Verfahren nach Anspruch 10, wobei Senden, durch die zweite Netzwerkvorrichtung, des ersten lokalen Komprimierungsparameters an eine erste Netzwerkvorrichtung Folgendes umfasst:
wenn eine voreingestellte Bedingung erfüllt ist, Senden, durch die zweite Netzwerkvorrichtung, des ersten lokalen Komprimierungsparameters an die erste Netzwerkvorrichtung, wobei
die voreingestellte Bedingung mindestens eines von dem Folgenden umfasst:
ein Komprimierungsverhältnis eines zweiten globalen Komprimierungsparameters, der in der zweiten Netzwerkvorrichtung gespeichert ist, kleiner als ein erster Schwellenwert oder gleich einem ersten Schwellenwert ist;
eine Anzahl von Paketen oder eine Bytelänge eines Pakets, verarbeitet durch die zweite Netzwerkvorrichtung, größer als ein zweiter Schwellenwert oder gleich einem zweiten Schwellenwert ist; und
eine Zeit der zweiten Netzwerkvorrichtung ein voreingestellter Zeitpunkt ist oder ein Zeitintervall ab einem Zeitpunkt, zu dem ein lokaler Komprimierungsparameter zuletzt an die erste Netzwerkvorrichtung gesendet wird, eine voreingestellte Zeitspanne erreicht oder überschreitet; und
Empfangen, durch die zweite Netzwerkvorrichtung, einer Synchronisierungsanforderung, die durch die erste Netzwerkvorrichtung gesendet wird, wobei die Synchronisierungsanforderung verwendet wird, um den ersten lokalen Komprimierungsparameter zu erfassen.

12. Verfahren nach Anspruch 10 oder Anspruch 11, wobei das Verfahren ferner Folgendes umfasst:
Erhalten, durch die zweite Netzwerkvorrichtung, der Komprimierungsrichtlinie, wobei die Komprimierungsrichtlinie eine Synchronisierungsrichtlinie und/oder eine Aufbewahrungsrichtlinie umfasst, die Synchronisierungsrichtlinie durch die zweite Netzwerkvorrichtung verwendet wird, um einen lokalen Komprimierungsparameter zu generieren und zu senden, und die Aufbewahrungsrichtlinie die zweite Netzwerkvorrichtung anweist, vor dem ersten globalen Komprimierungsparameter mindestens einen globalen Komprimierungsparameter zu speichern.

13. Netzwerkvorrichtung, wobei die Netzwerkvorrichtung konfiguriert ist, um das Verfahren nach einem der Ansprüche 1 bis 12 zu implementieren.

## Revendications

1. Procédé de traitement de données, dans lequel le procédé comprend :
l'obtention, par un premier dispositif réseau, d'un premier paramètre de compression local et d'un second paramètre de compression local, dans lequel le premier paramètre de compression local est généré par le premier dispositif réseau ou un deuxième dispositif réseau, et le second paramètre de compression local est généré par un troisième dispositif réseau ; et
la génération, par le premier dispositif réseau, d'un premier paramètre de compression global sur la base du premier paramètre de compression local et du second paramètre de compression local, dans lequel le premier paramètre de compression global est destiné à la compression et à la décompression,
dans lequel le procédé comprend en outre :
l'envoi, par le premier dispositif réseau, du premier paramètre de compression global à au moins un dispositif réseau, dans lequel l'au moins un dispositif réseau comprend l'un ou plusieurs des dispositifs réseau suivants : le deuxième dispositif réseau ou le troisième dispositif réseau ; et
dans lequel le procédé comprend en outre :
la communication, par le premier dispositif réseau, avec le deuxième dispositif réseau et/ou le troisième dispositif réseau sur la base d'un message de routage de passerelle de frontière, BGP, dans lequel les informations de communication comprennent l'un ou plusieurs des éléments suivants : une requête de synchronisation, le premier paramètre de compression local, le second paramètre de compression local, le premier paramètre de compression global, ou une première politique de compression.

2. Procédé selon la revendication 1, dans lequel le procédé comprend en outre :
l'envoi, par le premier dispositif réseau, de la requête de synchronisation au deuxième dispositif réseau et/ou au troisième dispositif réseau, pour requérir le premier paramètre de compression local et/ou le second paramètre de compression local.

3. Procédé selon la revendication 1 ou 2, dans lequel le procédé comprend en outre :
l'envoi, par le premier dispositif réseau, de la première politique de compression au deuxième dispositif réseau et/ou au troisième dispositif réseau, dans lequel la première politique de compression comprend une politique de synchronisation et/ou une politique de rétention, la politique de synchronisation est utilisée par le deuxième dispositif réseau et/ou le troisième dispositif réseau pour générer et envoyer un paramètre de compression local, et la politique de rétention indique au deuxième dispositif réseau et/ou au troisième dispositif réseau de stocker au moins un paramètre de compression global avant le premier paramètre de compression global.

4. Procédé selon la revendication 3, dans lequel la politique de synchronisation comprend un type de service et une politique de compression correspondant au type de service, et le type de service et la politique de compression correspondant au type de service indiquent au deuxième dispositif réseau et/ou au troisième dispositif réseau de traiter, sur la base du type de service et de la politique de compression correspondant au type de service, un paquet correspondant au type de service, et/ou de générer, sur la base du type de service et de la politique de compression correspondant au type de service, un paramètre de compression local correspondant au type de service.

5. Procédé selon l'une quelconque des revendications 1 à 4, dans lequel le procédé comprend en outre :
l'envoi, par le premier dispositif réseau, d'un premier identifiant à l'au moins un dispositif réseau, dans lequel le premier identifiant identifie le premier paramètre de compression global.

6. Procédé selon l'une quelconque des revendications 1 à 5, dans lequel le procédé comprend en outre :
l'obtention, par le premier dispositif réseau, d'une seconde politique de compression, dans lequel la politique de compression comprend l'un ou plusieurs des éléments suivants :
un moment ou une périodicité à laquelle le premier dispositif réseau génère/envoie le premier paramètre de compression global, un moment ou une périodicité à laquelle le premier dispositif réseau envoie la requête de synchronisation, le type de service et la politique de compression correspondante, et une condition prédéfinie, dans lequel
la condition prédéfinie indique au premier dispositif réseau d'envoyer le premier paramètre de compression global lorsque la condition prédéfinie est remplie.

7. Procédé selon l'une quelconque des revendications 1 à 6, dans lequel
le premier paramètre de compression local, le second paramètre de compression local et le premier paramètre de compression globale sont des dictionnaires ; et
le premier paramètre de compression local comprend une première chaîne, le second paramètre de compression comprend une seconde chaîne, et le premier paramètre de compression globale comprend un ensemble d'union de la première chaîne et de la seconde chaîne.

8. Procédé selon l'une quelconque des revendications 1 à 6, dans lequel
le premier paramètre de compression local est une première table de codage locale, le second paramètre de compression local est une seconde table de codage locale et le premier paramètre de compression globale est une première table de codage globale ; la première table de codage locale comprend une fréquence ou un nombre de fois d'un premier élément, la seconde table de codage locale comprend une fréquence ou un nombre de fois d'un second élément, et le premier élément et le second élément sont des éléments d'un ensemble de caractères de codage ; et
la génération, par le premier dispositif réseau, d'un premier paramètre de compression global sur la base du premier paramètre de compression local et du second paramètre de compression local comprend :
la génération, par le premier dispositif réseau, de la première table de codage globale sur la base la fréquence ou de la quantité de fois du premier élément et de la fréquence ou de la quantité de fois du second élément, dans lequel la première table de codage globale comprend des éléments dans l'ensemble de caractères de codage et le mot de code correspondant aux éléments.

9. Procédé selon l'une quelconque des revendications 6 à 8, dans lequel la condition prédéfinie comprend au moins l'un des éléments suivants :
l'heure du premier dispositif réseau est un moment prédéfini, ou un intervalle de temps à partir d'un moment auquel un paramètre de compression global est envoyé à l'au moins un dispositif réseau pour la dernière fois atteint ou dépasse une période de temps prédéfinie ;
une variation d'une quantité de temps d'occurrence ou d'une fréquence d'occurrence d'au moins un élément dans le premier paramètre de compression global est supérieure ou égale à un premier seuil ;
une différence entre une longueur d'une chaîne dans le premier paramètre de compression global et une longueur d'une chaîne dans le second paramètre de compression global est supérieure ou égale à un deuxième seuil ;
un rapport entre une longueur d'une chaîne dans le premier paramètre de compression global et une longueur d'une chaîne dans le second paramètre de compression global est supérieur ou égal à un troisième seuil ; et
dans un processus de génération du premier paramètre de compression global sur la base du second paramètre de compression global, un nombre de fois où une séquence de sous-chaînes ou d'éléments dans le second paramètre de compression global est ajustée est supérieur ou égal à un quatrième seuil.

10. Procédé de traitement de données, dans lequel le procédé comprend :
l'obtention, par un deuxième dispositif réseau, d'un premier paramètre de compression local ;
l'envoi, par le deuxième dispositif réseau, du premier paramètre de compression local à un premier dispositif réseau ;
la réception, par le deuxième dispositif réseau, d'un premier paramètre de compression global envoyé par le premier dispositif réseau, dans lequel le premier paramètre de compression global est généré sur la base d'un premier paramètre de compression local et d'un second paramètre de compression local ; et
la compression/décompression, par le deuxième dispositif réseau, des données cibles sur la base du premier paramètre de compression global, dans lequel les données cibles sont les données transmises par le deuxième dispositif réseau,
dans lequel le deuxième dispositif réseau communique avec le premier dispositif réseau sur la base d'un message de routage de passerelle de frontière, BGP, et des informations de communication comprennent l'un ou plusieurs des éléments suivants : une requête de synchronisation, le premier paramètre de compression local, le premier paramètre de compression global ou une politique de compression.

11. Procédé selon la revendication 10, dans lequel l'envoi, par le deuxième dispositif réseau, du premier paramètre de compression local à un premier dispositif réseau comprend :
si une condition prédéfinie est remplie, l'envoi, par le deuxième dispositif réseau, du premier paramètre de compression local au premier dispositif réseau, dans lequel
la condition prédéfinie comprend au moins l'un des éléments suivants :
un taux de compression d'un second paramètre de compression global stocké dans le deuxième dispositif réseau est inférieur ou égal à un premier seuil ;
une quantité de paquets ou une longueur en octets d'un paquet traité par le deuxième dispositif réseau est supérieure ou égale à un deuxième seuil ; et
l'heure du deuxième dispositif réseau est un moment prédéfini, ou un intervalle de temps à partir d'un moment auquel un paramètre de compression local est envoyé au premier dispositif réseau atteint ou dépasse pour la dernière fois une période de temps prédéfinie ; et
la réception, par le deuxième dispositif réseau, d'une requête de synchronisation envoyée par le premier dispositif réseau, dans lequel la requête de synchronisation est utilisée pour collecter le premier paramètre de compression local.

12. Procédé selon la revendication 10 ou la revendication 11, dans lequel le procédé comprend en outre :
l'obtention, par le deuxième dispositif réseau, de la politique de compression, dans lequel la politique de compression comprend une politique de synchronisation et/ou une politique de rétention, la politique de synchronisation est utilisée par le deuxième dispositif réseau pour générer et envoyer un paramètre de compression local, et la politique de rétention indique au deuxième dispositif réseau de stocker au moins un paramètre de compression global avant le premier paramètre de compression global.

13. Dispositif réseau, dans lequel le dispositif réseau est configuré pour mettre en œuvre le procédé selon l'une quelconque des revendications 1 à 12.
